# EUROPEAN PATENT SPECIFICATION

(11) **EP 4 261 886 B1**
(45) Date of publication and mention of the grant of the patent: **03.09.2025**
(21) Application number: 23166072.1
(22) Date of filing: 31.03.2023
(51) Int. Cl.: H10H 29/39, H10H 29/41

(54) **PIXEL AND DISPLAY DEVICE HAVING THE SAME**
PIXEL UND ANZEIGEVORRICHTUNG DAMIT
PIXEL ET DISPOSITIF D'AFFICHAGE LE COMPRENANT

(30) Priority: 11.04.2022 KR 20220044812
(43) Date of publication of application: 18.10.2023
(73) Proprietor: Samsung Display Co., Ltd., Yongin-si, Gyeonggi-do 17113 (KR)
(72) Inventor: KIM, Kyung Bae, 17113 Yongin-si (KR); PARK, Do Yeong, 17113 Yongin-si (KR); LEE, Ji Hye, 17113 Yongin-si (KR)
(74) Representative: Marks & Clerk LLP

(56) References cited:
- WO-A1-2021/162180
- US-A1- 2021 143 137
- US-A1- 2023 055 222

## Description

### BACKGROUND

### 1. Technical Field

The disclosure relates to a pixel with improved reliability and a display device having the same.

### 2. Description of the Related Art

The importance of display devices as communication media, has been emphasized because of the increasing development of information technology.

It is to be understood that this background of the technology section is, in part, intended to provide useful background for understanding the technology. However, this background of the technology section may also include ideas, concepts, or recognitions that were not part of what was appreciated by those skilled in the pertinent art prior to a corresponding effective filing date of the subject matter disclosed herein.

WO 2021/162180 A1 and US 2021/143137 A1 both provide disclosures related to display devices comprising pixels having alignments electrodes and a floating pattern.

### SUMMARY

According to an aspect, there is provided a pixel according to Claim 1. Details of embodiments are provided in the dependent claims.

### BRIEF DESCRIPTION OF THE

### DRAWINGS

An additional appreciation according to the embodiments of the invention will become more apparent by describing in detail the embodiments thereof with reference to the accompanying drawings, wherein:
FIG. 1 is a schematic perspective view of a light emitting element according to an embodiment;
FIG. 2 is a schematic cross-sectional view of the light emitting element in FIG. 1;
FIG. 3 is a schematic plan view of a display device according to an embodiment;
FIG. 4 is a schematic circuit diagram of electrical connections between components included in each of first to third sub-pixels shown in FIG. 3;
FIG. 5 is a schematic plan view of a pixel circuit layer of a pixel according to an embodiment;
FIG. 6 is a schematic plan view showing only a third conductive layer of the pixel in FIG. 5;
FIG. 7 is a schematic cross-sectional view of FIG. 5 taken along line I-I';
FIG. 8 is a schematic plan view of a display element layer of a pixel according to an embodiment;
FIG. 9 is a schematic plan view showing only first and second alignment electrodes, a floating pattern, light emitting elements, and a first bank that are included in the pixel in FIG. 8;
FIG. 10 is a schematic cross-sectional view of FIG. 8 taken along line II-II';
FIGS. 11 to 13 are schematic cross-sectional views of FIG. 8 taken along line III - III';
FIG. 14 is a schematic cross-sectional view of FIG. 8 taken along line IV - IV';
FIG. 15 is a schematic plan view of an optical layer of a pixel according to an embodiment;
FIGS. 16 and 17 are schematic cross-sectional views of FIG. 15 taken along line V-V'; and
FIG. 18 is a schematic cross-sectional view of FIG. 15 taken along line VI -VI'.

### DETAILED DESCRIPTION OF THE EMBODIMENTS

In the following description, for the purposes of explanation, numeral specific details are set forth in order to provide an understanding of various embodiments or implementations of the disclosure. As used herein "embodiments" and "implementations" are interchangeable words that are non-limiting examples of devices or methods disclosed herein. It is apparent, however, that the various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment. The scope of protection is defined by the claims.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristics, attribute, property, etc., or the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

Although the terms "first," "second," etc., may be used herein to describe various types of elements, these elements could not be limited by these terms. These terms are only used to distinguish one element from another element. Thus, a first element discussed below could be termed a second element without departing from the teachings of the disclosure. Similarly, a second element may also be named a first element.

In this specification, terms such as "comprise", "include", or "have" are used to designate presence of features, figures, steps, operations, elements, parts, or combinations thereof, which are described in the specification, and it should be understood that presence or addition possibilities of one or more other features or figures, steps, operations, elements, parts, or combinations thereof are not excluded in advance.

When an element such as a layer, film, region, or substrate is referred to as being "on," "connected to," or "coupled to" another element or layer, it may be directly on, connected to, or coupled to the other element or layer or intervening elements or layers may be present. When however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

Spatially relative terms, such as "beneath," "below," "under," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operations, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors use herein should be interpreted accordingly.

When "an element (e.g., 'first element') is referred to as being "(functionally or communicatively) coupled to another element (e.g., 'second element') (operatively or communicatively) or as being "connected to" the another element, the element may be directly connected to the another element, or may be connected thereto through the another element (e.g., 'third element'). In contrast, when an element (e.g., 'first element') is referred to as being "directly coupled" or "directly connected" to the other element (e.g., 'second element'), another element (e.g., 'third element') does not exist between the element and the other component.

The terminology used herein is for the purpose of describing particular embodiments and is not intended to be limiting. As used herein, the singular forms, "a, " "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the disclosure. Further, the blocks, units, and/or modules of some embodiments may be physically combined into more complex blocks, units, and/or modules without departing from the scope of the disclosure.

The terms "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

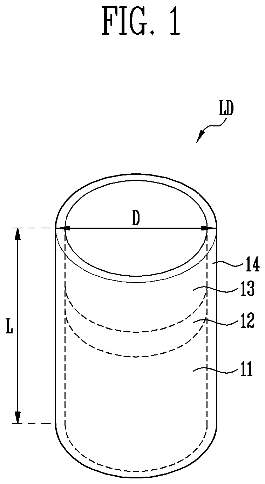

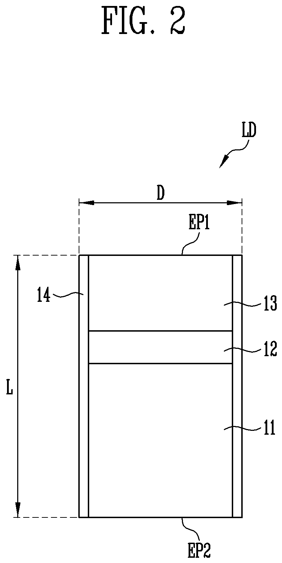

FIG. 1 is a schematic perspective view of a light emitting element LD according to an embodiment. FIG. 2 is a schematic cross-sectional view of the light emitting element LD in FIG. 1.

Referring to FIGS. 1 and 2, the light emitting element LD may include a first semiconductor layer 11, a second semiconductor layer 13, and an active layer 12 interposed between the first and second semiconductor layers 11 and 13. For example, the light emitting element LD may be implemented as an emission stack (or referred to as "stack pattern") in which the first semiconductor layer 11, the active layer 12, and the second semiconductor layer 13 are sequentially laminated. In the embodiment, types and/or shapes of the light emitting element LD are not limited to the embodiments illustrated in FIGS. 1 and 2.

The light emitting element LD may be formed in a shape extending in a direction. When the extending direction of the light emitting element LD is defined as a length direction, the light emitting element LD may include a first end EP1 and a second end EP2 that are opposite to each other in the length direction. One of the first semiconductor layer 11 and the second semiconductor layer 13 may be positioned in the first end EP1 of the light emitting element LD, and another of the first semiconductor layer 11 and the second semiconductor layer 13 may be positioned in the second end EP2 of the light emitting element LD. For example, the second semiconductor layer 13 may be positioned in the first end EP1 of the light emitting element LD, and the first semiconductor layer 11 may be positioned in the second end EP2 of the light emitting element LD.

The light emitting element LD may have various shapes. For example, as shown in FIG. 1, the light emitting element LD may have a rod-like shape, a bar-like shape, or a pillar-like shape, which is long in the length direction (or has an aspect ratio greater than about 1). As another example, the light emitting element LD may have a rod-like shape, a bar-like shape, or a pillar-like shape, which is short in the length direction (or has an aspect ratio smaller than about 1). As another example, the light emitting element LD may have a rod-like shape, a bar-like shape, or a pillar-like shape, which has an aspect ratio of about 1.

The light emitting element LD may include, for example, a light emitting diode (LED) fabricated and having a subminiature size (e.g., with a diameter D and/or a length L in a range of nano scale (or nanometer) to micro scale (or micrometer)).

When the light emitting element LD is long in the length direction (e.g., when the aspect ratio is greater than about 1), the diameter D of the light emitting element LD may be about 0.5 *µ*m to about 6 µm, and the length L thereof may be about 1 *µ*m to about 10 *µ*m. However, the diameter D and the length L of the light emitting element LD are not limited thereto, and the size of the light emitting element LD may be changed according to a lighting device or a display device which has the light emitting element LD to emit light independently and satisfies a required condition (or a design condition).

The first semiconductor layer 11 may include, for example, at least one n-type semiconductor layer. For example, the first semiconductor layer 11 may include at least one semiconductor material of InAlGaN, GaN, AlGaN, InGaN, AlN, and InN, and may be an n-type semiconductor layer doped with at least one dopant of Si, Ge, and Sn, which has a first conductivity (or an n-type dopant). However, the materials of the first semiconductor layer 11 are not limited thereto, and the first semiconductor layer 11 may be formed of various materials. In some embodiments, the first semiconductor layer 11 may include a top surface and a bottom surface. The top surface of the first semiconductor layer 11 may contact the active layer 12 in the length direction of the light emitting element LD. The bottom surface may be exposed to the outside.

The active layer 12 (or an emission layer) may be located on the first semiconductor layer 11, and may have a single or multiple quantum well structure. For example, when the active layer 12 has the multiple quantum well structure, a barrier layer (not shown), a strain reinforcing layer, and a well layer may be periodically and repeatedly laminated (e.g., laminated as a part) in the active layer 12. The strain reinforcing layer may further increase a strain (e.g., a compressive strain) applied to the well layer because the strain reinforcing layer has a smaller lattice constant than the barrier layer. However, the structure of the active layer 12 is not limited to the embodiment described above.

The active layer 12 may emit light with a wavelength in a range of about 400 nm to about 900 nm, and may use a double hetero structure. In an embodiment, a clad layer doped with a conductive dopant may also be formed on and/or under the active layer 12 in the length direction of the light emitting element LD. For example, the clad layer may be formed as an AlGaN layer or an InAlGaN layer. In some embodiments, the materials such as AlGaN and InAlGaN may be used to form the active layer 12. However, the disclosure is not limited thereto, and the active layer 12 may be formed of various materials. The active layer 12 may include a first surface and a second surface. The first surface of the active layer 12 may contact the first semiconductor layer 11, and the second surface of the active layer 12 may contact the second semiconductor layer 13.

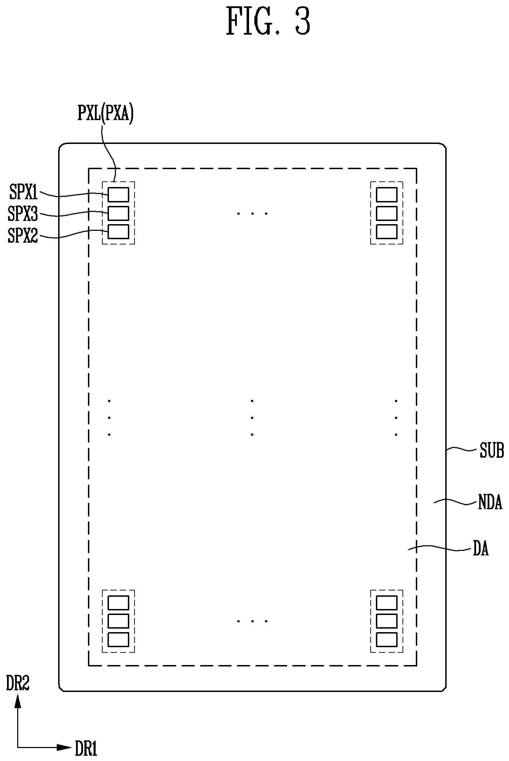

When an electric field having a voltage (e.g., a certain voltage) or greater is applied between opposite ends of the light emitting element LD, electron-hole pairs are combined in the active layer 12 and the light emitting element LD may emit light. Since the emission of the light emitting element LD is controlled by the combination of the electron-hole pairs, the light emitting element LD may be used as a light source (or an emission source) of the various light emitting devices including a pixel PXL (e.g., refer to FIG. 3) of the display device.

The second semiconductor layer 13 may be located on the second surface of the active layer 12, and may include a semiconductor layer of a different type from that of the first semiconductor layer 11. For example, the second semiconductor layer 13 may include at least one p-type semiconductor layer. For example, the second semiconductor layer 13 may include at least one semiconductor material of InAlGaN, GaN, AlGaN, InGaN, AlN, and InN, and may include a p-type semiconductor layer doped with at least one dopant of Mg, Zn, Ca, Sr, and Ba, which has a second conductivity (or a p-type dopant). However, the materials of the second semiconductor layer 13 are not limited thereto, and the second semiconductor layer 13 may be formed of various materials. In some embodiments, the second semiconductor layer 13 may include a bottom surface and a top surface. The bottom surface of the second semiconductor layer 13 may contact the second surface of the active layer 12 in the length direction of the light emitting element LD. The top surface may be exposed to the outside.

In an embodiment, the first semiconductor layer 11 and the second semiconductor layer 13 may have different thicknesses in the length direction of the light emitting element LD. For example, the first semiconductor layer 11 may have a relatively greater thickness than the second semiconductor layer 13 in the length direction of the light emitting element LD. Accordingly, the active layer 12 of the light emitting element LD may be positioned closer to the top surface of the second semiconductor layer 13 than to the bottom surface of the first semiconductor layer 11.

Although the first semiconductor layer 11 and the second semiconductor layer 13 are each formed as a layer, the disclosure is not limited thereto. In the embodiment, depending on the materials of the active layer 12, each of the first semiconductor layer 11 and the second semiconductor layer 13 may further include at least one or more layers (e.g., a clad layer and/or a tensile strain barrier reducing (TSBR) layer). The TSBR layer may be a strain reducing layer located between the semiconductor layers and serve as a buffer for reducing a lattice constant difference between the semiconductor layers. The TSBR layer may be formed as a p-type semiconductor layer including at least one of p-GaInP, p-AlInP, and p-AlGaInP, but the disclosure is not limited thereto.

In some embodiments, the light emitting element LD may also include a contact electrode (hereinafter referred to as a "first contact electrode") disposed on the second semiconductor layer 13, the first semiconductor layer 11, the active layer 12, and the second semiconductor layer 13 that are described above. According to another embodiment, another contact electrode (hereinafter referred to as a "second contact electrode") may be disposed at an end of the first semiconductor layer 11.

Each of the first and second contact electrodes may be an ohmic contact electrode, but the disclosure is not limited thereto. In some embodiments, the first and second contact electrodes may be a Schottky contact electrode. The first and second contact electrodes may include a conductive material. For example, the first and second contact electrodes may include an opaque metal in which at least one of chromium (Cr), titanium (Ti), aluminum (Al), gold (Au), nickel (Ni), and oxides or alloys thereof is used alone or mixed, but the disclosure is not limited thereto. In some embodiments, the first and second contact electrodes may also include at least one transparent conductive oxide of an indium tin oxide (ITO), an indium zinc oxide (IZO), a zinc oxide (ZnOₓ), an indium gallium zinc oxide (IGZO), and an indium tin zinc oxide (ITZO). The zinc oxide (ZnOₓ) may be a zinc oxide (ZnO), and/or a zinc peroxide (ZnO₂).

The materials included in the first and second contact electrodes may be the same as or different from each other. The first and second contact electrodes may be substantially transparent or translucent. Accordingly, light generated from the light emitting element LD may pass through each of the first and second contact electrodes and may be emitted out of the light emitting element LD. In some embodiments, when the light generated from the light emitting element LD does not pass through the first and second contact electrodes and is emitted out of the light emitting element LD through a region other than the first end EP1 or the second end EP2 of the light emitting element LD, the first and second contact electrodes may also include an opaque metal.

In an embodiment, the light emitting element LD may further include an insulating layer 14. However, in some embodiments, the insulating layer 14 may be omitted. In other embodiments, the insulating layer 14 may cover some of the first semiconductor layer 11, the active layer 12, and the second semiconductor layer 13.

The insulating layer 14 may prevent the active layer 12 from short-circuiting due to contacting conductive material other than the first and second semiconductor layers 11 and 13. The insulating layer 14 may reduce or minimize a surface defect of the light emitting element LD and improve lifetime and emission efficiency of the light emitting element LD. When multiple light emitting elements LD are closely located, the insulating layer 14 may reduce or prevent an unwanted short circuit between the light emitting elements LD. In other embodiments, in case that the active layer 12 may prevent a short circuit with an external conductive material, the insulating layer 14 may not be limited (may be omitted).

The insulating layer 14 may be adjacent to (e.g., entirely surround) an external circumferential surface of the light emitting laminated body including the first semiconductor layer 11, the active layer 12, and the second semiconductor layer 13.

In the embodiment above-described, the insulating layer 14 may be adjacent to (e.g., entirely surround) the external circumferential surface of the first semiconductor layer 11, the active layer 12, and the second semiconductor layer 13, but the disclosure is not limited thereto. In some embodiments, when the light emitting element LD includes the first contact electrode, the insulating layer 14 may be adjacent to (e.g., entirely surround) the external circumferential surface of the first semiconductor layer 11, the active layer 12, and the second semiconductor layer 13, and an external circumferential surface of the first contact electrode. In some embodiments, the insulating layer 14 may not entirely surround the external circumferential surface of the first contact electrode or may be adjacent to (e.g., surround) some of the external circumferential surface of the first contact electrode. The insulating layer 14 may not surround the rest of the external circumferential surface of the first contact electrode. In some embodiments, when the first contact electrode is disposed in the first end EP1 of the light emitting element LD, and the second contact electrode is disposed in the second end EP2 of the light emitting element LD, the insulating layer 14 may also expose at least one region of each of the first and second contact electrodes.

The insulating layer 14 may include a transparent insulating material. For example, the insulating layer 14 may include one or more insulating materials selected from a group of a silicon oxide (SiOₓ), a silicon nitride (SiNₓ), a silicon oxynitride (SiOₓN_{y}), an aluminum oxide (AlOₓ), a titanium oxide (TiOₓ), a hafnium oxide (HfOₓ), a titanium strontium oxide (SrTiOₓ), a cobalt oxide (CoₓO_{y}), a magnesium oxide (MgO), a zinc oxide (ZnOₓ), a ruthenium oxide (RuOₓ), a nickel oxide (NiO), a tungsten oxide (WOₓ), a tantalum oxide (TaOₓ), a gadolinium oxide (GdOₓ), a zirconium oxide (ZrOₓ), a gallium oxide (GaOₓ), a vanadium oxide (V_{xOy}), ZnO:Al, ZnO:B, In_{xOy}:H, a niobium oxide (Nb_{xOy}), a magnesium fluoride (MgFx), an aluminum fluoride (AlFₓ), an Alucone polymer film, a titanium nitride (TiN), a tantalum nitride (TaN), an aluminium nitride (AlN_{X}), a gallium nitride (GaN), a tungsten nitride (WN), a hafnium nitride (HfN), a niobium nitride (NbN), a gadolinium nitride (GdN), a zirconium nitride (ZrN), and a vanadium nitride (VN), but the disclosure is not limited thereto, and various materials having an insulating property may be used as the material of the insulating layer 14.

The insulating layer 14 may be provided as a single layer, or may be provided as multiple layers including at least two layers. For example, when the insulating layer 14 is formed as a double layer including a first layer and a second layer that are sequentially laminated, the first layer and the second layer may be formed of different materials (or substances), and may be formed by different processes. In some embodiments, the first layer and the second layer may include a same material, and the first layer and the second layer may be formed by continuous processes.

In some embodiments, the light emitting element LD may be implemented as a light emitting pattern with a core-shell structure. The first semiconductor layer 11 may be positioned at a core (e.g., at a center of the light emitting element LD). The active layer 12 may be adjacent to (e.g., surround) an external circumferential surface of the first semiconductor layer 11. The second semiconductor layer 13 may be adjacent to (e.g., surround) the active layer 12. The light emitting element LD may further include a contact electrode adjacent to (e.g., surrounding) at least one side of the second semiconductor layer 13. In some embodiments, the light emitting element LD may be provided on the external circumferential surface of the light emitting pattern with the core-shell structure, and may further include an insulating layer 14 that includes a transparent insulating material. The light emitting element LD implemented as the light emitting pattern with the core-shell structure may be manufactured by a deposition method.

The light emitting element LD may be an emission source (or a light source) of various display devices. The light emitting element LD may be manufactured by a surface treatment process. For example, when multiple light emitting elements LD are mixed with a fluid solution (or a solvent) and supplied to each pixel area (e.g., the emission area of each pixel or the emission area of each sub-pixel), each of the light emitting element LD may be surfacetreated and the light emitting elements LD may uniformly sprayed (or distributed) without being agglomerated in the solution.

An emission component (or a light emitting device or a light emitting part) including the light emitting element LD may be used in various kinds of electronic devices (e.g., the display devices) that require a light source. For example, when multiple light emitting elements LD are disposed in the pixel area of each pixel of a display panel, the light emitting elements LD may be used as a light source of each pixel. However, the field of application of the light emitting element LD is not limited to the example described above. For example, the light emitting element LD may be used in other kinds of electronic devices that require a light source such as a lighting device.

FIG. 3 is a schematic plan view of a display device according to an embodiment.

In FIG. 3, for ease of description, detailed description of a display area DA of the display device in which an image is displayed is provided below.

The display device may be applied to a display surface of electronic devices such as a smartphone, a television, a tablet personal computer (PC), a mobile phone, a video phone, an electronic-book reader, a desktop PC, a laptop PC, a netbook computer, a workstation, a server, a personal digital assistant (PDA), a portable multimedia player (PMP), a MP3 player, a medical device, a camera, or a wearable device, the disclosure may be applied to the display device.

Referring to FIGS. 1 and 3, the display device may include a substrate SUB, pixels PXL that are provided on the substrate SUB, a driver provided on the substrate SUB and drive the pixels PXL, and a line component that electrically connects the pixels PXL and the driver. Each of the pixels PXL may include at least one light emitting element LD.

The display device may be classified into a passive matrix type display device and an active matrix type display device according to a driving method of the light emitting element LD. For example, when the display device is implemented as an active matrix type display device, each of the pixels PXL may include a driving transistor, a switching transistor, or the like. The driving transistor of each of the pixels PXL may control an amount of current supplied to the light emitting element LD, and the switching transistor of each of the pixels PXL may transmit a data signal to the driving transistor.

The display device may have various shapes. For example, the display device may have a rectangular plate shape having two pairs of sides extending in a direction (e.g., in parallel with each other), but the disclosure is not limited thereto. When the display device has the rectangular plate shape, any one of the two pairs of sides may be longer than another pair of sides. For convenience of explanation, the display device having a rectangular shape with a pair of long sides and a pair of short sides is shown. An extending direction of the long side of the display device may be indicated by a second direction DR2 and an extending direction of the short side of the display device may be indicated by a first direction DR1. In the display device having the rectangular plate shape, a corner portion in which the long side and the short side contact (or meet) may have a round shape, but the disclosure is not limited thereto.

The substrate SUB may include the display area DA and a non-display area NDA.

The display area DA may be an area in which pixels PXL for displaying an image is provided. The non-display area NDA may be an area in which some of the driver for driving the pixels PXL and the line component for electrically connecting the pixels PXL and the driver are provided.

The non-display area NDA may be positioned adjacent to the display area DA. The non-display area NDA may be provided at least one side of the display area DA. For example, the non-display area NDA may be adjacent to (e.g., surround) a circumference (or an edge) of the display area DA. The line component electrically connected to the pixels PXL and the driver electrically connected to the line component to drive the pixels PXL may be provided in the non-display area NDA.

The line component may electrically connect the driver and the pixels PXL. The line component may provide a signal to each pixel PXL (or each sub-pixel), and signal lines (e.g., a fan-out line electrically connected to a scan line, a data line, and an emission control line) that are electrically connected to each pixel PXL. In some embodiments, the line component may include signal lines (e.g., a fan-out line electrically connected to a control line, a sensing line, or the like) and a sensing line. The signal lines may be electrically connected to each pixel PXL. The sensing line may compensate for a change in electrical characteristics of each pixel PXL in real time. The line component may provide a voltage to each pixel PXL, and may include the fan-out line electrically connected to power lines which are electrically connected to each pixel PXL.

The substrate SUB may include a transparent insulating material and light may pass through the transparent insulating material. The substrate SUB may be a rigid substrate or a flexible substrate.

A region on the substrate SUB may be provided as the display area DA and the pixels PXL may be disposed thereon. Another region on the substrate SUB may be provided as the non-display area NDA. For example, the substrate SUB may include the display area DA that includes the pixel areas in which each pixel PXL is disposed, and the non-display area NDA disposed around the display area DA (or adjacent to the display area DA).

Each of the pixels PXL may be provided in the display area DA on the substrate SUB. In an embodiment, the pixels PXL may be arranged in the display area DA as a stripe arrangement structure, but the disclosure is not limited thereto.

A first sub-pixel SPX1, a second sub-pixel SPX2, and a third sub-pixel SPX3 may be provided in the pixel area PXA in which each of the pixels PXL is provided. In the embodiment, the first sub-pixel SPX1 may be a red pixel (or a red sub-pixel), the second sub-pixel SPX2 may be a green pixel (or a green sub-pixel), and a third sub-pixel SPX3 may be a blue pixel (or a blue sub-pixel). However, the disclosure is not limited thereto, and according to an embodiment, the second sub-pixel SPX2 may be a red pixel, the first sub-pixel SPX1 may be a green pixel, the third sub-pixel SPX3 may be a blue pixel. According to another embodiment, the third sub-pixel SPX3 may be a red pixel, the first sub-pixel SPX1 may be a green pixel, and the second sub-pixel SPX2 may be a blue pixel. The first sub-pixel SPX1, the third sub-pixel SPX3, and the second sub-pixel SPX2 may be sequentially arranged in the second direction DR2, but the disclosure is not limited thereto.

The first sub-pixel SPX1 may include a first pixel circuit and a first emission component (or a first emission part), the second sub-pixel SPX2 may include a second pixel circuit and a second emission component (or a second emission part), and the third sub-pixel SPX3 may include a third pixel circuit and a third emission component (or a third emission part).

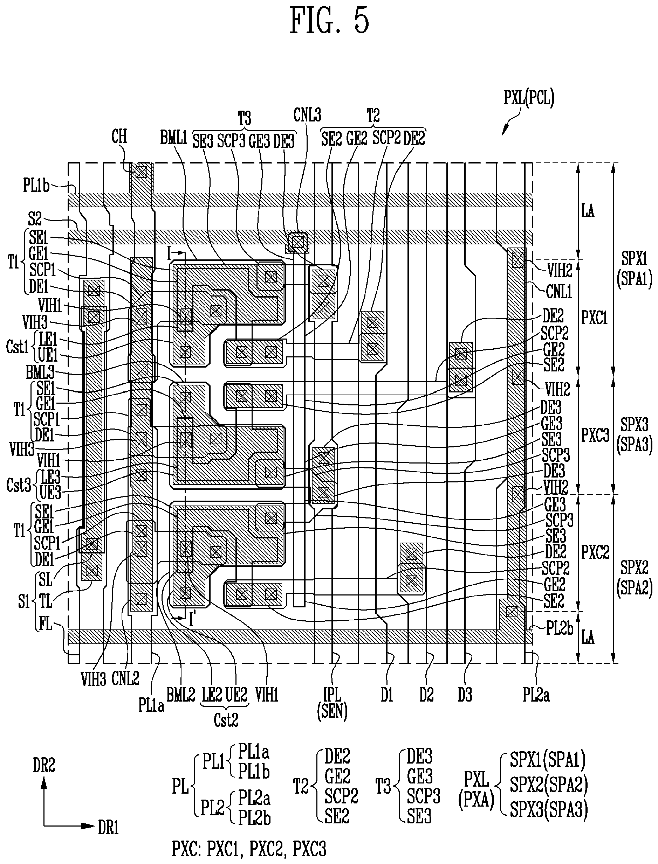

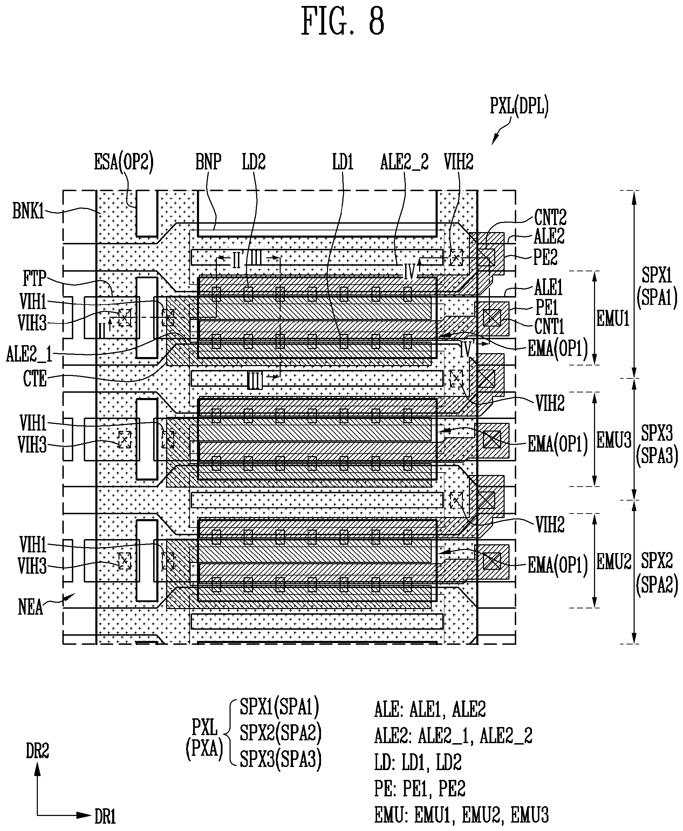

The first, second, and third pixel circuits and the first, second, and third emission components may be disposed on different layers, and may overlap each other in a plan view. For example, the first, second, and third pixel circuits may be disposed in a pixel circuit layer PCL (e.g., refer to FIGS. 5 to 7) of the sub-pixel area in which each sub-pixel is disposed. The first, second, and third emission components may be disposed in a display element layer DPL (e.g., refer to FIGS. 8 to 14) that overlaps the pixel circuit layer PCL in a corresponding one of the first, second, and third sub-pixels SPX1, SPX2, and SPX3 in a plan view.

A first alignment electrode and a second alignment electrode may be spaced apart from each other and disposed in the first, second, and third emission components. The light emitting element LD may be disposed between the first alignment electrode and the second alignment electrode. Detailed description of the components disposed in the pixel area PXA are provided below with reference to FIGS. 5 to 18.

Each pixel PXL may include at least one light emitting element LD driven by corresponding scan signal and data signal. The light emitting element LD may have a size as small as nano-scale (or nanometer) to micro-scale (or micrometer) and may be electrically connected in a direction to (e.g., in parallel to) adjacent light emitting elements, but the disclosure is not limited thereto. The light emitting element LD may serve as a light source of each pixel PXL (or each sub-pixel).

Each pixel PXL (or each sub-pixel) may include at least one light source (e.g., the light emitting element LD shown in FIG. 1) driven by a signal (e.g., a scan signal, a data signal, etc.) and/or a power source (e.g., a first driving power source and a second driving power source). However, a kind of the light emitting element LD that may be used as a light source of each pixel PXL (or each sub-pixel) in an embodiment is not limited thereto.

The driver may supply a signal and a power source to each pixel PXL (or each sub-pixel) through the line component, and control driving of the respective pixel PXL (or the respective sub-pixel).

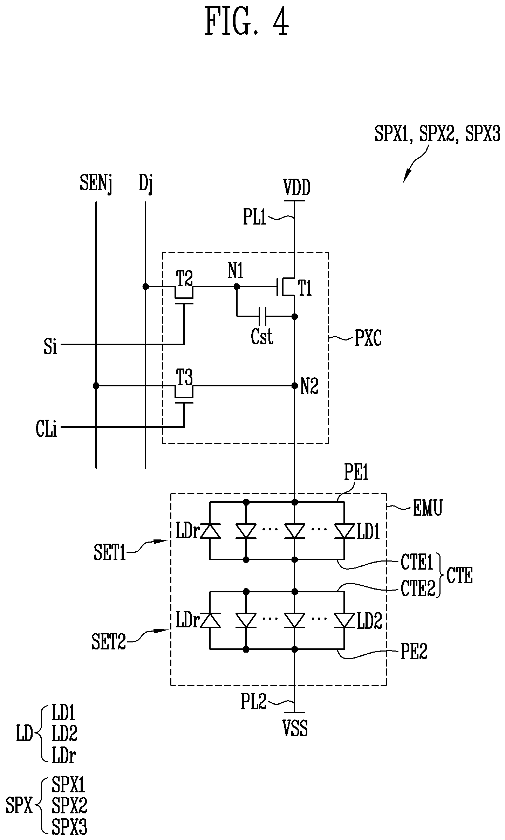

FIG. 4 is a schematic circuit diagram of electrical connections between components included in each of the first to third sub-pixels SPX1, SPX2, and SPX3 shown in FIG. 3.

For example, the electrical connections between the components included in each of the first to third sub-pixels SPX1, SPX2, and SPX3 applicable to an active matrix type display device is illustrated in FIG. 4 according to an embodiment. However, the connections between the components of each of the first to third sub-pixels SPX1, SPX2, and SPX3 are not limited thereto. In the following embodiment, the first sub-pixel SPX1, the second sub-pixel SPX2, and the third sub-pixel SPX3 are collectively referred to as the sub-pixel SPX or the sub-pixels SPX.

Referring to FIG. 1 to FIG. 4, the sub-pixel SPX may include an emission component EMU (or emission part) that emits light with luminance corresponding to a data signal. The sub-pixel SPX may selectively further include a pixel circuit PXC for driving the emission component EMU.

In some embodiments, the emission component EMU may include light emitting elements LD that are electrically connected between a first power line PL1 and a second power line PL2. The first power line PL1 may be electrically connected to a first driving power supply VDD and applied with a voltage of the first driving power supply VDD. The second power line PL2 may be electrically connected to a second driving power supply VSS and applied with the voltage of the second driving power supply VSS. For example, the emission component EMU may include a first electrode PE1 (or a first pixel electrode), a second electrode PE2 (or a second pixel electrode), and the light emitting elements LD. The first electrode PE1 may be electrically connected to the first driving power supply VDD via the pixel circuit PXC and the first power line PL1. The second electrode PE2 may be electrically connected to the second driving power supply VSS via the second power line PL2. The light emitting elements LD may be electrically connected in a direction (e.g., in parallel in a same direction) between the first electrode PE1 and the second electrode PE2. In an embodiment, the first electrode PE1 may be an anode, and the second electrode PE2 may be a cathode.

Each of the light emitting elements LD included in the emission component EMU may include a first end electrically connected to the first driving power supply VDD via the first electrode PE1 and the pixel circuit PXC, and a second end electrically connected to the second driving power supply VSS via the second electrode PE2. The first driving power supply VDD and the second driving power supply VSS may have different potentials. For example, the first driving power supply VDD may be set as a high potential power supply (or may supply a high potential power), and the second driving power supply VSS may be set as a low potential power supply (or may supply a low potential power). A potential difference between the first and second driving power supplies VDD and VSS may be set to be greater than or equal to a threshold voltage of the light emitting elements LD for the emission period of each sub-pixel SPX.

As described above, each of the light emitting elements LD may be electrically connected in a direction (e.g., in parallel in a same direction or a forward direction) between the first electrode PE1 and the second electrode PE2. Voltages of different power supplies may be supplied to the first electrode PE1 and the second electrode PE2. Each of the light emitting elements LD may form each of effective light sources.

The light emitting elements LD of the emission component EMU may emit light with a luminance corresponding to a driving current supplied by the corresponding pixel circuit PXC. For example, the driving current corresponding to a gray level value of corresponding frame data of the pixel circuit PXC may be supplied to the emission component EMU for each frame period. The driving current supplied to the emission component EMU may be divided into the light emitting elements LD and flow through each of the light emitting elements LD. Accordingly, each light emitting element LD may emit the light with the luminance corresponding to the current flowing therethrough, and the emission component EMU may emit the light with the luminance corresponding to the driving current.

In the embodiment described above, opposite ends of the light emitting elements LD may be electrically connected in a same direction between the first and second driving power supplies VDD and VSS, but the disclosure is not limited thereto. In some embodiments, the emission component EMU may further include at least one invalid light source (e.g., a reverse light emitting element LDr) and the light emitting elements LD that form valid light sources. The reverse light emitting element LDr and the light emitting elements LD may be electrically connected in a direction (e.g., in parallel) between the first and second electrodes PE1 and PE2. The reverse light emitting element LDr may be electrically connected between the first and second electrodes PE1 and PE2 in a direction opposite to that of the light emitting elements LD. The reverse light emitting element LDr may maintain a non-active state even if a driving voltage (e.g., a certain driving voltage or a forward driving voltage) is applied between the first and second electrodes PE1 and PE2. Thus, current may not substantially flow through the reverse light emitting element LDr.

The pixel circuit PXC may be electrically connected to a scan line and a data line Dj of the sub-pixel SPX. The pixel circuit PXC may be electrically connected to a control line CLi and a sensing line SENj of the sub-pixel SPX. For example, in case that the sub-pixel SPX is disposed in an i-th row and a j-th column of the display area DA, the pixel circuit PXC of the sub-pixel SPX may be electrically connected to an i-th scan line Si, a j-th data line Dj, an i-th control line CLi, and a j-th sensing line SENj of the display area DA.

The pixel circuit PXC may include a first transistor T1, a second transistor T2, a third transistor T3, and a storage capacitor Cst.

The first transistor T1 may be electrically connected between the first driving power supply VDD and the emission component EMU as a driving transistor for controlling the driving current applied to the emission component EMU. For example, a first terminal of the first transistor T1 may be electrically connected to the first driving power supply VDD via the first power line PL1, a second terminal of the first transistor T1 may be electrically connected to a second node N2, and a gate electrode of the first transistor T1 may be electrically connected to a first node N1. The first transistor T1 may control, according to a voltage applied to the first node N1, an amount of the driving current that flows from the first driving power supply VDD to the emission component EMU through the second node N2. In the embodiment, the first terminal of the first transistor T1 may be a drain electrode, the second terminal of the first transistor T1 may be a source electrode, but the disclosure is not limited thereto. In some embodiments, the first terminal of the first transistor T1 may be a source electrode and the second terminal of the first transistor T1 may be a drain electrode.

The second transistor T2 may select the sub-pixel SPX in response to the scan signal, and may be electrically connected between the data line Dj (e.g., the j-th data line) and the first node N1 as a switching transistor for activating the sub-pixel SPX. A first terminal of the second transistor T2 may be electrically connected to the data line Dj, a second terminal of the second transistor T2 may be electrically connected to the first node N1, and a gate electrode of the second transistor T2 may be electrically connected to the scan line Si (e.g., the i-th scan line). The first terminal and the second terminal of the second transistor T2 are different terminals. For example, when the first terminal is a drain electrode, the second terminal may be a source electrode.

The second transistor T2 may be turned on when a scan signal having a gate-on voltage (e.g., a high level voltage) is supplied to the gate electrode of the second transistor T2 from the scan line Si, and may electrically connect the data line Dj and the first node N1. The first node N1 may be a point to which the second terminal of the second transistor T2 and the gate electrode of the first transistor T1 are electrically connected, and the second transistor T2 may transmit the data signal to the gate electrode of the first transistor T1.

The first transistor T1 may be electrically connected to the sensing line SENj (e.g., the j-th sensing line), and the third transistor T3 may obtain the sensing signal through the sensing line SENj. Thus, the third transistor T3 may detect characteristics of the sub-pixel SPX including a threshold voltage of the first transistor T1 and the like by using the sensing signal. Information about the characteristics of the sub-pixel SPX may be used to convert image data, and a characteristic deviation between the sub-pixels SPX may be compensated for. A second terminal of the third transistor T3 may be electrically connected to the second terminal of the first transistor T1. A first terminal of the third transistor T3 may be electrically connected to the sensing line SENj. A gate electrode of the third transistor T3 may be electrically connected to the control line CLi (e.g., the i-th control line). The first terminal of the third transistor T3 may be electrically connected to an initialization power source. The third transistor T3 may be implemented with an initialization transistor capable of initializing the second node N2. The third transistor T3 may be turned on to transmit a voltage of the initialization power source to the second node N2 when the sensing control signal is supplied from the control line CLi. Accordingly, a second storage electrode of the storage capacitor Cst electrically connected to the second node N2 may be initialized.

The storage capacitor Cst includes a first storage electrode (or a lower electrode) and a second storage electrode (or an upper electrode). The first storage electrode of the storage capacitor Cst may be electrically connected to the first node N1, and the second storage electrode of the storage capacitor Cst may be electrically connected to the second node N2. The storage capacitor Cst may be charged with a data voltage corresponding to the data signal supplied to the first node N1 for a frame period. Accordingly, the storage capacitor Cst may store a voltage that corresponds to a difference between a voltage of the gate electrode of the first transistor T1 and a voltage of the second node N2.

The emission component EMU may be configured to include at least one serial stage that includes multiple light emitting elements LD electrically connected to each other in series. In an embodiment, the emission component EMU may have a serial-parallel mixed structure as shown in FIG. 4. For example, the emission component EMU may also include a first serial stage SET1 and a second serial stage SET2 electrically connected each other.

The first serial stage SET1 and the second serial stage SET2 of the emission component EMU may be sequentially and electrically connected between the first driving power supply VDD and the second driving power supply VSS. Each of the first and second serial stages SET1 and SET2 may include two electrodes PE1 and CTE1 and PE2 and CTE2 that form an electrode pair of the corresponding serial stage, and the light emitting elements LD electrically connected in a direction (e.g., in parallel in a same direction) between the two electrodes PE1 and CTE1 and PE2 and CTE2. For example, the first serial stage SET1 may include the two electrodes PE1 and CTE1, and the second serial stage SET2 may include the two electrodes PE2 and CTE2.

The first serial stage SET1 may include the first electrode PE1 and a first intermediate electrode CTE1, and may include at least one first light emitting element LD1 electrically connected between the first electrode PE1 and the first intermediate electrode CTE1. The first serial stage SET1 may also include a reverse light emitting diode LDr electrically connected between the first electrode PE1 and the first intermediate electrode CTE1 in the direction opposite to that of the first light emitting element LD1.

The second serial stage SET2 may include a second intermediate electrode CTE2 and the second electrode PE2, and may include at least one second light emitting element LD2 electrically connected between the second intermediate electrode CTE2 and the second electrode PE2. The second serial stage SET2 may also include a reverse light emitting element LDr electrically connected between the second intermediate electrode CTE2 and the second electrode PE2 in the direction opposite to that of the second light emitting element LD2.

The first intermediate electrode CTE1 and the second intermediate electrode CTE2 may form the intermediate electrode CTE that electrically connects the first serial stage SET1 and the second serial stage SET2, which are sequentially disposed. When the first intermediate electrode CTE1 and the second intermediate electrode CTE2 are integral with each other, the first intermediate electrode CTE1 and the second intermediate electrode CTE2 may be different regions (or different portions) of the intermediate electrode CTE.

In the embodiment described above, the first electrode PE1 of the first serial stage SET1 may be an anode of the emission component EMU of each sub-pixel SPX, and the second electrode PE2 of the second serial stage SET2 may be a cathode of the emission component EMU.

As described above, the emission component EMU of the sub-pixel SPX may include the serial stages SET1 and SET2 (or the light emitting elements LD) electrically connected in a serial-parallel mixed structure. Thus, the emission component EMU of the sub-pixel SPX may readily adjust a driving current/voltage condition suitable for a product specification to be applied.

In other embodiments, when compared with an emission component having a structure in which the light emitting elements LD are electrically connected only in parallel, the emission component EMU of the sub-pixel SPX including the serial stages SET1 and SET2 (or the light emitting elements LD) electrically connected in the serial-parallel mixed structure may decrease the driving current. When compared with the emission component having a structure in which a same number of light emitting elements LD are all electrically connected in series, the emission component EMU of the sub-pixel SPX including the serial stages SET1 and SET2 electrically connected in the serial-parallel mixed structure may decrease the driving voltage applied to opposite ends of the emission component EMU. Furthermore, when compared with the emission component having a structure with all serial stages electrically connected in series, the emission component EMU of the sub-pixel SPX including the serial stages SET1 and SET2 (or the light emitting elements LD) electrically connected in the serial-parallel mixed structure may include a larger number of light emitting elements LD between a same number of electrodes PE1, CTE1, CTE2, and PE2. For example, the emission component EMU of the embodiment may decrease the driving current and the driving voltage applied to the opposite ends of the emission component EMU. Thus, the number of the light elements LD in each emission component EMU may be increased. Emission efficiency of the light emitting elements LD may be improved, and even if a fault occurs at a serial stage (or a specific serial stage), a ratio of the light emitting elements LD that do not emit light due to the fault may be relatively reduced. Thus, a decrease in the emission efficiency of the light emitting elements LD may be prevented.

In the following embodiment, for ease of description, a horizontal direction on a plane is indicated by a first direction DR1, a vertical direction on the plane is indicated by a second direction DR2, and a vertical direction on a cross-section is indicated by a third direction DR3.

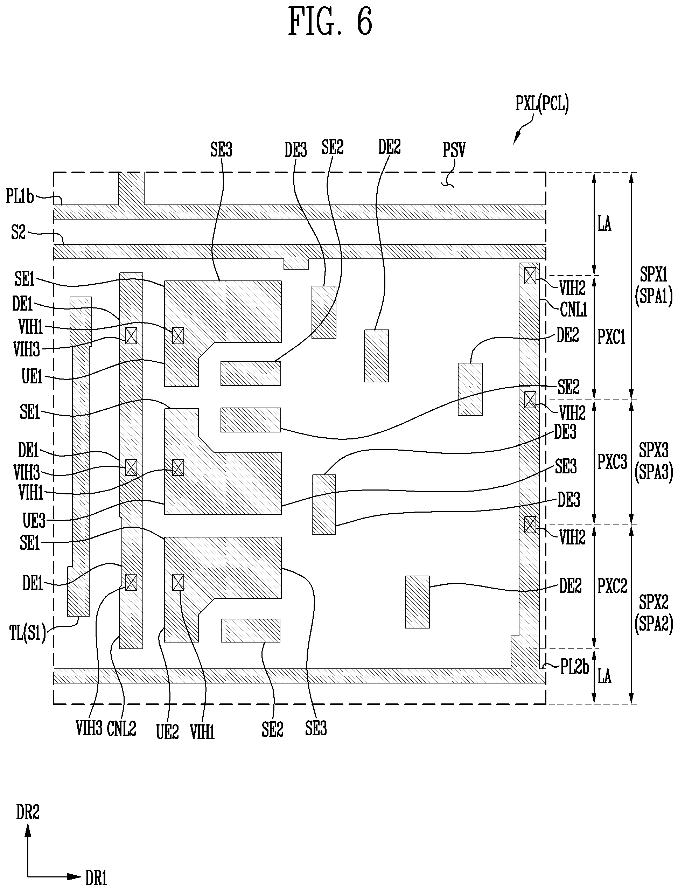

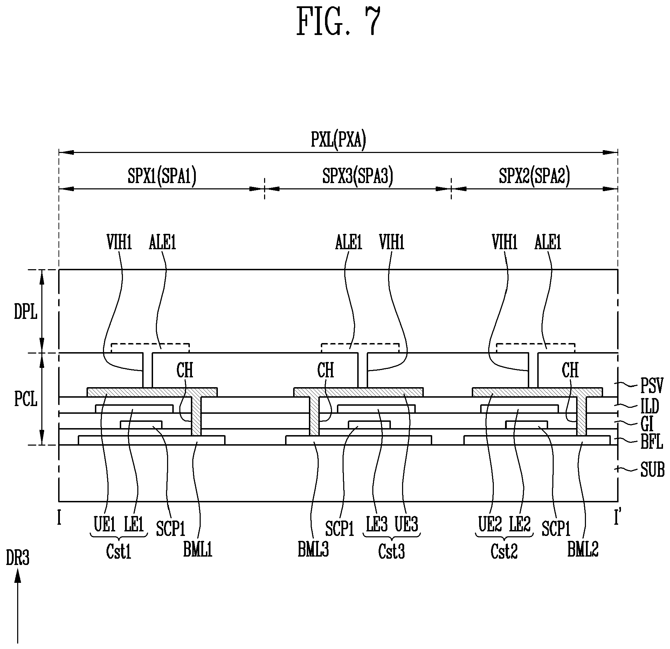

FIG. 5 is a schematic plan view of a pixel circuit layer PCL of a pixel according to an embodiment PXL. FIG. 6 is a schematic plan view showing only a third conductive layer included in the pixel PXL in FIG. 5. FIG. 7 is a schematic cross-sectional view of FIG. 5 taken along line I-I'.

For example, FIG. 5 schematically shows the structure of the pixel circuit layer PCL and the pixel area PXA in which the pixel PXL is disposed.

In FIG. 7, the pixel circuit layer PCL the of pixel PXL is simplified to show each electrode having a single layer and each insulating layer having a single layer, but the disclosure is not limited thereto.

In FIGS. 5 to 7, regions in which the components are provided (or positioned) and components included in the pixel PXL are collectively referred to as a pixel PXL.

Referring to FIGS. 1 to 7, the pixel circuit layer PCL of the pixel PXL may include multiple pixel circuits PXC that are disposed in the pixel area PXA. For example, the pixel circuit layer PCL may include a first pixel circuit PXC1 disposed in a first sub-pixel area SPA1, a second pixel circuit PXC2 disposed in a second sub-pixel area SPA2, and a third pixel circuit PXC3 disposed in a third sub-pixel area SPA3. The first sub-pixel area SPA1 may be a region of the pixel area PXA in which the first sub-pixel SPX1 is positioned. The second sub-pixel area SPA2 may be a region of the pixel area PXA in which the second sub-pixel SPX2 is positioned. The third sub-pixel SPA3 may be a region of the pixel area PXA in which the third sub-pixel SPX3 is positioned.

The pixel area PXA may include a line area LA. The line area LA may be provided around each of the first and second sub-pixel areas SPA1 and SPA2 and/or provided in a part thereof. For example, the line area LA may be provided over the first sub-pixel area SPA1 and under the second sub-pixel area SPA2. For example, the line area LA may be provided on an upper portion of the first sub-pixel area SPA1 and a lower portion of a second sub-pixel area SPA2 of an adjacent pixel PXL. The line area LA may be an area in which wires extending in the first direction DR1 are disposed. For example, a first horizontal power line PL1b, a second horizontal power line PL2b, and a second scan line S2 that extend in the first direction DR1 may be disposed in the line g area LA.

The pixel circuit layer PCL may include at least one insulating layer disposed on the substrate SUB. For example, the pixel circuit layer PCL may include a buffer layer BFL, a gate insulating layer GI, an interlayer insulating layer ILD, and a passivation layer PSV that are sequentially laminated on the substrate SUB in the third direction DR3.

The buffer layer BFL may be disposed (e.g., entirely disposed) on the substrate SUB. The buffer layer BFL may prevent impurities from diffusing into the transistors T1, T2, and T3 that are included in the first to third pixel circuits PXC1, PXC2, and PXC3. The buffer layer BFL may be an inorganic insulating layer that includes an inorganic material. The buffer layer BFL may include at least one of a silicon nitride (SiNₓ), a silicon oxide (SiOₓ), a silicon oxynitride (SiOₓN_{y}), and an aluminum oxide (AlOₓ). The buffer layer BFL may be provided as a single layer, but may also be provided as multiple layers having at least two layers. When the buffer layer BFL is provided as the multiple layers, each layer may be formed of a same material or different materials. The buffer layer BFL may be omitted depending on the materials and process conditions of the substrate SUB.

The gate insulating layer GI may be disposed on a surface (e.g., an overall surface) of the buffer layer BFL. The gate insulating layer GI and the buffer layer BFL may include a same material. For example, the gate insulating layer GI may include a suitable (or selected) material from the materials of the buffer layer BFL. For example, the gate insulating layer GI may be an inorganic insulating layer that includes an inorganic material.

The interlayer insulating layer ILD may be provided and/or formed on a surface (or an overall surface) of the gate insulating layer GI. The interlayer insulating layer ILD and the buffer layer BFL may include a same material. For example, the interlayer insulating layer ILD may include one or more suitable (or selected) materials from the materials of the buffer layer BFL.

The passivation layer PSV may be provided and/or formed on a surface (or an overall surface) of the interlayer insulating layer ILD. The passivation layer PSV may be an organic insulating layer including an organic material or an inorganic insulating layer including an inorganic material. The inorganic insulating layer of the passivation layer PSV may include, for example, at least one of a silicon oxide (SiOₓ), a silicon nitride (SiNₓ), a silicon oxynitride (SiOₓN_{y}), and an aluminum oxide (AlOₓ). The organic insulating layer of the passivation layer PSV may include, for example, at least one of a polyacrylates resin, an epoxy resin, a phenolic resin, a polyamides resin, a polyimides rein, an unsaturated polyesters resin, a poly-phenylen ethers resin, a poly-phenylene sulfides resin, and a benzocyclobutene resin.

The passivation layer PSV may be partially opened to expose some of each of the first, second, and third pixel circuits PXC1, PXC2, and PXC3. For example, the passivation layer PSV may be partially opened to include a first via hole VIH1 (e.g., a "first through-hole" or a "first contact hole") through which a first upper electrode UE1 of the first pixel circuit PXC1, a second upper electrode UE2 of the second pixel circuit PXC2, and a third upper electrode UE3 of the third pixel circuit PXC are respectively exposed. The passivation layer PSV may be partially opened to include three second via holes VIH2 through which a region of a first connecting line CNL1 of the pixel circuit layer PCL is exposed. The passivation layer PSV may be partially opened to include three third via holes VIH3 through which a region of a second connecting line CNL2 of the pixel circuit layer PCL is exposed.

The pixel circuit layer PCL may include at least one or more conductive layers disposed between the insulating layers described above. For example, the pixel circuit layer PCL may include a first conductive layer, a second conductive layer, and a third conductive layer. The first conductive layer may be disposed between the substrate SUB and the buffer layer BFL. The second conductive layer may be disposed on the gate insulating layer GI. The third conductive layer may be disposed on the interlayer insulating layer ILD.

The first conductive layer may be formed as single layer made of at least one selected from a group of copper (Cu), molybdenum (Mo), tungsten(W), aluminum-neodymium (AlNd), titanium (Ti), aluminum (Al), silver (Ag), and an alloy thereof. In other embodiments, the first conductive layer may be formed as a double layer or a multi-layer structure including at least of molybdenum (Mo), titanium (Ti), copper(Cu), aluminum (Al), and silver (Ag), which is a low-resistive material. Thus, a wiring resistance may be reduced. Each of the second and third conductive layers and the first conductive layer may include a same material. For example, each of the second and third conductive layers may include one or more suitable materials from the materials of the first conductive layer, but the disclosure is not limited thereto.

In an embodiment, the substrate SUB may include a transparent insulating material. Thus, the substrate SUB may pass light and have light transmission. The substrate SUB may be a rigid substrate or a flexible substrate.

The rigid substrate may be, for example, at least one of a glass substrate, a quartz substrate, a glass-ceramic substrate, and a crystallized glass substrate.

The flexible substrate may be one of a film substrate and a plastic substrate, which includes a polymer organic material. For example, the flexible substrate may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

The pixel circuit layer PCL may further include contact holes CH for electrically connecting circuit elements (e.g., predetermined or selectable circuit elements), electrodes, and/or wires, which are disposed in the pixel circuit layer PCL on the substrate SUB. For convenience of explanation, in FIG. 5, only one contact hole CH is denoted by a symbol to represent the contact holes CH for electrically connecting the elements (or the specific or selectable elements) in the pixel circuit layer PCL.

The pixel circuit layer PCL may further include wires disposed on the substrate SUB and electrically connected to the pixels PXL. For example, the pixel circuit layer PCL may include scan lines S1 and S2, data lines D1, D2, and D3, a power line PL, and an initialization power line IPL.

The scan lines S1 and S2 may include a first scan line S1 and a second scan line S2 spaced apart from each other.

The first scan line S1 may extend in the second direction DR2. A signal (e.g., a scan signal or a control signal) may be applied to the first scan line S1. In an embodiment, a first conductive pattern FL (or a first layer), a second conductive pattern SL (or a second layer), and a third conductive pattern TL (or a third layer) may be successively stacked, and the first scan line S1 may have a multilayer structure. The first conductive pattern FL may be formed as (or included in) the first conductive layer. The second conductive pattern SL may be formed as (or included in) the second conductive layer. The third conductive pattern TL may be formed as (or included in) the third conductive layer. The first conductive pattern FL, the second conductive pattern SL, and the third conductive pattern TL may be electrically connected to each other through the corresponding contact hole CH. In some embodiments, the first scan line S1 may also be provided as a single layer including only the first conductive pattern FL formed as (or included in) the first conductive layer. A scan signal and/or a control signal may be supplied to the first scan line S1.

The second scan line S2 may extend in the first direction DR1 intersecting the extending direction of the first scan line S1. The second scan line S2 may be formed as a single layer that includes the third conductive layer. The second scan line S2 may be electrically connected to the first scan line S1 through the corresponding contact hole CH. The second scan line S2 may be electrically connected to a third connecting line CNL3 through the corresponding contact hole CH.

The third connecting line CNL3 may be formed as (or included in) the second conductive layer, and may be electrically connected to the second scan line S2 through the corresponding contact hole CH. Accordingly, a signal (e.g., a predetermined or selectable signal) applied to the second scan line S2 may be transmitted to the third connecting line CNL3. The third connecting line CNL3 may be electrically connected to some of each of the first, second, and third pixel circuits PXC1, PXC2, and PXC3 through the corresponding contact hole CH. For example, the third connecting line CNL3 may be electrically and/or physically connected to the second gate electrode GE2 of the second transistor T2 of the corresponding pixel circuit PXC and the third gate electrode GE3 of the third transistor T3.

The data lines D1, D2, and D3 may be spaced apart from each other in the first direction DR1, and may include a first data line D1, a second data line D2, and a third data line D3 that extend in the second direction DR2. The corresponding data signal may be applied to each of the first, second, and third data lines D1, D2, and D3. In an embodiment, each of the first, second, and third data lines D1, D2, and D3 may be formed as a single layer that includes the first conductive layer, but the disclosure is not limited thereto. In some embodiments, each of the first, second, and third data lines D1, D2, and D3 may also be formed as multiple layers in which at least two of the first, second, and third conductive layers are laminated.

Each of the first, second, and third data lines D1, D2, and D3 may be electrically connected to the first, second, and third pixel circuits PXC1, PXC2, and PXC3 through the corresponding contact hole CH. For example, the first data line D1 may be electrically connected to the second transistor T2 of the first pixel circuit PXC1 through the corresponding contact hole CH. The second data line D2 may be electrically connected to the second transistor T2 of the second pixel circuit PXC2 through the corresponding contact hole CH. The third data line D3 may be electrically connected to the second transistor T2 of the third pixel circuit PXC3 through the corresponding contact hole CH.

The power line PL may include the first power line PL1 and the second power line PL2 that are spaced apart from each other.

The first power line PL1 may include a first vertical power line PL1a extending in the second direction DR2, and a first horizontal power line PL1b extending in the first direction DR1. The voltage of the first driving power supply VDD may be applied to the first power line PL1.

The first vertical power line PL1a and the first horizontal power line PL1b may be disposed on different layers, and may be electrically connected to each other through the corresponding contact hole CH. For example, the first vertical power line PL1a may be formed as (or included in) the first conductive layer. The first horizontal power line PL1b may be formed as (or included in) the third conductive layer. The first vertical power line PL1a and the first horizontal power line PL1b may be electrically connected to each other through the corresponding contact hole CH. The first power line PL1 may have a mesh structure due to the first vertical power line PL1a and the first horizontal power line PL1b electrically connected to each other.

In an embodiment, the first vertical power line PL1a may overlap in a plan view the second connecting line CNL2 extending in the second direction DR2, and may be electrically connected to the second connecting line CNL2 through the corresponding contact hole CH.

The second connecting line CNL2 may be formed as (or included in) the third conductive layer. The second connecting line CNL2 and some of each of the first, second, and third pixel circuits PXC1, PXC2, and PXC3 may be integral with each other. For example, the second connecting line CNL2 and a first drain electrode DE1 of the first transistor T1 of each of the first, second, and third pixel circuits PXC1, PXC2, and PXC3 may be integral with each other. In an embodiment, the second connecting line CNL2 may be electrically connected to some of the display element layer DPL through the third via hole VIH3 that passes through the passivation layer PSV. For example, the second connecting line CNL2 may be electrically connected to a floating pattern FTP (e.g., refer to FIG. 8) of the display element layer PDL through the third via hole VIH3 that passes through the passivation layer PSV.

The second power line PL2 may include a second vertical power line PL2a extending in the second direction DR2, and a second horizontal power line PL2b extending in the first direction DR1. The voltage of the second driving power supply VSS may be applied to the second power line PL2.

The second vertical power line PL2a and the second horizontal power line PL2b may be disposed on different layers, and may be electrically connected to each other through the corresponding contact hole CH. For example, the second vertical power line PL2a may be formed as (or included in) the first conductive layer. The second horizontal power line PL2b may be formed as (or included in) the third conductive layer. The second vertical power line PL2a and the second horizontal power line PL2b may be electrically connected to each other through the corresponding contact hole CH. The second power line PL2 may have a mesh structure due to the second vertical power line PL2a and the second horizontal power line PL2b electrically connected to each other.

In an embodiment, the second horizontal power line PL2b extending in the first direction DR1 and the first connecting line CNL1 extending in the second direction DR2 may be integral with each other. For example, the first connecting line CNL1 may protrude from a region of the second horizontal power line PL2b in the second direction DR2, and may overlap the second vertical power line PL2a in a plan view. The first connecting line CNL1 may be formed as (or included in) the third conductive layer, and may be electrically connected to second vertical power line PL2a through the corresponding contact hole CH.

In an embodiment, the first connecting line CNL1 may be electrically connected to some of the display element layer DPL through the second via hole VIH2 that passes through the passivation layer PSV. For example, the first connecting line CNL1 may be electrically connected to the second alignment electrode ALE2 (e.g., refer to FIG. 8) of the display element layer PDL through the second via hole VIH2 that passes through the passivation layer PSV.

The initialization power line IPL may extend in the second direction DR2, and may be formed as (or included in) the first conductive layer. A voltage of the initialization power supply may be applied to the initialization power line IPL for a period (e.g., a certain or predetermined period). Accordingly, the voltage of the initialization power supply may be applied to each of the first, second, and third sub-pixels SPX1, SPX2, and SPX3. In some embodiments, the initialization power line IPL may be used as a sensing line SNE that detects characteristics of each sub-pixel SPX from the third transistor T3 of each of the first, second, and third sub-pixels SPX1, SPX2, and SPX3 for a period (e.g., a certain or predetermined period).

The first pixel circuit PXC1, the second pixel circuit PXC2, and the third pixel circuit PXC3 may have substantially a similar or identical structure. The first pixel circuit PXC1 of the first to third pixel circuits PXC1, PXC2, and PXC3 is primarily described, and the second and third pixel circuits PXC2 and PXC3 are briefly described.

The first pixel circuit PXC1 may include a first transistor T1, a second transistor T2, a third transistor T3, and a first storage capacitor Cst1.

The first transistor T1 of the first pixel circuit PXC1 may include a first gate electrode GE1, a first semiconductor pattern SCP1, a first source electrode SE1, and a first drain electrode DE1.

The first gate electrode GE1 may be formed as (or included in) the second conductive layer, and may be electrically connected to a second source electrode SE2 of the second transistor T2 through the corresponding contact hole CH.

The first semiconductor pattern SCP1 may include a channel region that overlaps the first gate electrode GE1 in a plan view. The first semiconductor pattern SCP1 may include a first contact region (or a source region) and a second contact region (or a drain region). The first contact region and the second contact region of the first semiconductor pattern SCP1 may be positioned at opposite sides of the channel region. The first semiconductor pattern SCP1 may be a semiconductor layer made of at least one of poly silicon, amorphous silicon, and an oxide semiconductor. The channel region of the first semiconductor pattern SCP1 may be a semiconductor layer not doped with impurities, and the first and second contact regions of the first semiconductor pattern SCP1 may be a semiconductor layer doped with impurities.

The first semiconductor pattern SCP1 may be disposed between the buffer layer BFL and the gate insulating layer GI. For example, the first semiconductor pattern SCP1 may be positioned on the buffer layer BFL, and may be adjacent to (e.g., surrounded by) the gate insulating layer GI.

The first source electrode SE1 may be formed as (or included in) the third conductive layer, and may overlap the first gate electrode GE1 in the first sub-pixel area SPA1 in a plan view. The first source electrode SE1 may be electrically connected to the first contact region of the first semiconductor pattern SCP1 through the corresponding contact hole CH. The first source electrode SE1 may be electrically connected to a first lower metal pattern BML1 through the corresponding contact hole CH.

The first lower metal pattern BML1 may be formed as (or included in) the first conductive layer, and may overlap the first gate electrode GE1 and the first source electrode SE1 in the first sub-pixel area SPA1 in a plan view. When the first lower metal pattern BML1 is electrically connected to the first source electrode SE1 through the corresponding contact hole CH, a driving range of the voltage supplied to the first gate electrode GE1 may increase. The first lower metal pattern BML1 may be electrically connected to the first transistor T1, and floating of the first lower metal pattern BML1 may be prevented.

The first drain electrode DE1 may be formed as (or included in) the third conductive layer. The first drain electrode DE1 and the second connecting line CNL2 may be integral with each other and electrically connected to the first vertical power line PL1a. The first drain electrode DE1 may be electrically connected to the second contact region of the first semiconductor pattern SCP1 through the corresponding contact hole CH.

The second transistor T2 of the first pixel circuit PXC1 may include a second gate electrode GE2, a second semiconductor pattern SCP2, a second source electrode SE2, and a second drain electrode DE2.

The second gate electrode GE2 may be disposed in the first sub-pixel area SPA1 and spaced apart from the first gate electrode GE1. The second gate electrode GE2 may be disposed in the second conductive layer. The second gate electrode GE2 and the third connecting line CNL3 may be integral with each other. The second gate electrode GE2 may be supplied with the signal (e.g., the scan signal) applied to the second scan line S2.

The second semiconductor pattern SCP2 may include a channel region that overlaps the second gate electrode GE2 in a plan view. The second semiconductor pattern SCP2 may include a first contact region (or a source region) and a second contact region (or a drain region). The first contact region and the second contact region of the second semiconductor pattern SCP2 may be positioned at opposite sides of the channel region. The second semiconductor pattern SCP2 may be a semiconductor layer made of at least one of poly silicon, amorphous silicon, and an oxide semiconductor. The channel region of the second semiconductor pattern SCP2 may be a semiconductor layer not doped with impurities, and the first and second contact regions of the second semiconductor pattern SCP2 may be a semiconductor layer doped with impurities.

The second semiconductor pattern SCP2 and the first semiconductor pattern SCP1 may be disposed on a same layer. For example, the second semiconductor pattern SCP2 may be disposed between the buffer layer BFL and the gate insulating layer GI.

The second source electrode SE2 may be formed as (or included in) a third conductive layer, and may overlap the first gate electrode GE1 of the first transistor T1 in a plan view. The second source electrode SE2 may be electrically connected to a first connection region of the second semiconductor pattern SCP2 through the corresponding contact hole CH. The second source electrode SE2 may be electrically connected to the first gate electrode GE1 through the corresponding contact hole CH.

The second drain electrode DE2 may be formed as (or included in) the third conductive layer, and may overlap a first data line D1 in a plan view. The second drain electrode DE2 may be electrically connected to the second contact region of the second semiconductor pattern SCP2 through the corresponding contact hole CH. The second drain electrode DE2 may be electrically connected to the first data line D1 through the corresponding contact hole CH.

The third transistor T3 of the first pixel circuit PXC1 may include a third gate electrode GE3, a third semiconductor pattern SCP3, a third source electrode SE3, and a third drain electrode DE3.

The third gate electrode GE3 may be formed as (or included in) the second conductive layer. The third gate electrode GE3 and the third connecting line CNL3 may be integral with each other. The third gate electrode GE3 may be supplied with a signal (e.g., a control signal) applied to the second scan line S2.

The third semiconductor pattern SCP3 may include a channel region that overlaps the third gate electrode GE3 in a plan view. The third semiconductor pattern SCP3 may include a first contact region (or a source region) and a second contact region (or a drain region). The first contact region and the second contact region of the third semiconductor pattern SCP3 may be positioned at opposite sides of the channel region. The third semiconductor pattern SCP3 may be a semiconductor layer made of at least one of poly silicon, amorphous silicon, and an oxide semiconductor. The channel region of the third semiconductor pattern SCP3 may be a semiconductor layer not doped with impurities, and the first and second contact regions of the third semiconductor pattern SCP3 may be a semiconductor layer doped with impurities.

The third semiconductor pattern SCP3 and the first and second semiconductor patterns SCP1 and SCP2 may be disposed on a same layer. For example, the third semiconductor pattern SCP3 may be disposed between the buffer layer BFL and the gate insulating layer GI.

The third source electrode SE3 may be formed as (or included in) the third conductive layer. The third source electrode SE3 and the first source electrode SE1 may be integral with each other. The third source electrode SE3 may be electrically connected to the first contact region of the third semiconductor pattern SCP3 through the corresponding contact hole CH. The third source electrode SE3 may be electrically connected to the first lower metal pattern BML1 through the corresponding contact hole CH.

The third drain electrode DE3 may be formed as (or included in) the third conductive layer, and may be electrically connected to the second contact region of the third semiconductor pattern SCP3 through the corresponding contact hole CH. The third drain electrode DE3 may be electrically connected to the initialization power line IPL through the corresponding contact hole CH.

The first storage capacitor Cst1 may include a first lower electrode LE1 (or a first storage electrode) and a first upper electrode UF1 (or a second storage electrode). The first lower electrode LE1 and the first gate electrode GE1 may be integral with each other. The first upper electrode UE1 may overlap the first lower electrode LE1 in a plan view. The first upper electrode UF1 may be formed as (or included in) the third conductive layer. The first upper electrode UE1 and the first and third source electrodes SE1 and SE3 may be integral with each other.

The first upper electrode UE1, the first source electrode SE1, and the third source electrode SE3 may be electrically connected to the first lower metal pattern BML1 through the corresponding contact hole CH.

In an embodiment, the first upper electrode UE1 may be electrically connected to some of the display element layer DPL through the first via hole VIH1 that passes through the passivation layer PSV. For example, the first upper electrode UE1 may be electrically connected to the first alignment electrode ALE1 of the display element layer DPL through the first via hole VIH1 that passes through the passivation layer PSV.

The second pixel circuit PXC2 may include a first transistor T1, a second transistor T2, a third transistor T3, and a second storage capacitor Cst2.

The first transistor T1 of the second pixel circuit PXC2 may include a first gate electrode GE1, a first semiconductor pattern SCP1, a first source electrode SE1, and a first drain electrode DE1. The first transistor T1 may further include a second lower metal pattern BML2 electrically connected to the first source electrode SE1 through the corresponding contact hole CH.

The second lower metal pattern BML2 may be formed as (or included in) the first conductive layer, and may overlap the first transistor T1 in a plan view. The second lower metal pattern BML2 may be electrically connected to the first source electrode SE1 through the corresponding contact hole CH.

The second transistor T2 of the second pixel circuit PXC2 may include a second gate electrode GE2, a second semiconductor pattern SCP2, a second source electrode SE2, and a second drain electrode DE2.

The second drain electrode DE2 may be formed as (or included in) the third conductive layer, and may overlap a second data line D2 in a plan view. The second drain electrode DE2 may be electrically connected to the second contact region of the second semiconductor pattern SCP2 through the corresponding contact hole CH. The second drain electrode DE2 may be electrically connected to the second data line D2 through the corresponding contact hole CH.

The third transistor T3 of the second pixel circuit PXC2 may include a third gate electrode GE3, a third semiconductor pattern SCP3, a third source electrode SE3, and a third drain electrode DE3.

The second storage capacitor Cst2 may include a second lower electrode LE2 and a second upper electrode UE2. The second lower electrode LE2 and the first gate electrode GE1 may be integral with each other. The second upper electrode UE2 may overlap the second lower electrode LE2 in a plan view. The second upper electrode UE2 may be formed as (or included in) the third conductive layer. The second upper electrode UE2 and the first and third source electrodes SE1 and SE3 may be integral with each other.

The second upper electrode UE2, the first source electrode SE1, and the third source electrode SE3 may be electrically connected to the second lower metal pattern BML2 through the corresponding contact hole CH. In an embodiment, the second upper electrode UE2 may be electrically connected to some of the display element layer DPL through another first via hole VIH1 that passes through the passivation layer PSV. For example, the second upper electrode UE2 may be electrically connected to the first alignment electrode ALE1 of the display element layer DPL through another first via hole VIH1 that passes through the passivation layer PSV.

The third pixel circuit PXC3 may include a first transistor T1, a second transistor T2, a third transistor T3, and a third storage capacitor Cst3.

The first transistor T1 of the third pixel circuit PXC3 may include a first gate electrode GE1, a first semiconductor pattern SCP1, a first source electrode SE1, and a first drain electrode DE1. The first transistor T1 may further include a third lower metal pattern BML3 electrically connected to the first source electrode SE1 through the corresponding contact hole CH.

The third lower metal pattern BML3 may be formed as (or included in) the first conductive layer, and may overlap the first transistor T1 in a plan view. The third lower metal pattern BML3 may be electrically connected to the first source electrode SE1 through the corresponding contact hole CH.

The second transistor T2 of the third pixel circuit PXC3 may include a second gate electrode GE2, a second semiconductor pattern SCP2, a second source electrode SE2, and a second drain electrode DE2.

The second drain electrode DE2 may be formed as (or included in) the third conductive layer, and may overlap a third data line D3 in a plan view. The second drain electrode DE2 may be electrically connected to the second contact region of the second semiconductor pattern SCP2 through the corresponding contact hole CH. The second drain electrode DE2 may be electrically connected to the third data line D3 through the corresponding contact hole CH.

The third transistor T3 of the third pixel circuit PXC3 may include a third gate electrode GE3, a third semiconductor pattern SCP3, a third source electrode SE3, and a third drain electrode DE3.

The third storage capacitor Cst may include a third lower electrode LE3 and a third upper electrode UE3.

The third lower electrode LE3 and the first gate electrode GE1 may be integral with each other.

The third upper electrode UE3 may overlap the third lower electrode LE3 in a plan view. The third upper electrode UE3 may be formed as (or included in) the third conductive layer. The third upper electrode UE3 and the first and third source electrodes SE1 and SE3 may be integral with each other. In an embodiment, the third upper electrode UE3 may be electrically connected to some of the display element layer DPL through another first via hole VIH1 that passes through the passivation layer PSV. For example, the third upper electrode UE3 may be electrically connected to the first alignment electrode ALE1 of the display element layer DPL through another first via hole VIH1 that passes through the passivation layer PSV.

Each of the first, second, and third pixel circuits PXC1, PXC2, and PXC3 may be covered by the passivation layer PSV.

The passivation layer PSV may include via holes that are positioned in the pixel area PXA in which each pixel PXL is disposed. For example, the passivation layer PSV may include the first via hole VIH1, the second via hole VIH2, and the third via hole VIH3. For example, the passivation layer PSV may include multiple first via holes VIH1, multiple second via holes VIH2, and multiple third via holes VIH3.

The first via hole VIH1 may be positioned in each of the first, second, and third sub-pixel areas SPA1, SPA2, and SPA3, and may expose a region of the upper electrode in a corresponding one of the first, second, and third sub-pixel areas SPA1, SPA2, and SPA3. In an embodiment, a first via hole VIH1 may be positioned in each of the first, second, and third sub-pixel areas SPA1, SPA2, and SPA3, but the disclosure is not limited thereto.

The first upper electrode UE1, the third upper electrode UE3, and the second upper electrode UE2 may be sequentially arranged in the second direction DR2, and the first upper electrode UE1, the third upper electrode UE3, and the second upper electrode UE2 may be positioned in a same column. In an embodiment, the first via hole VIH1 of the first sub-pixel area SPA1 (or the first sub-pixel SPX1), the first via hole VIH1 of the third sub-pixel area SPA3 (or the third sub-pixel SPX3), and the first via hole VIH1 of the second sub-pixel area SPA2 (or the second sub-pixel SPX2) are positioned on a same line (or are collinear with each other) in the second direction DR2. According to the invention, the first via hole VIH1 of the first sub-pixel area SPA1, the first via hole VIH1 of the third sub-pixel area SPA3, and the first via hole VIH1 of the second sub-pixel area SPA2 are positioned in the same column.

The second via hole VIH2 may positioned in each of the first, second, and third sub-pixel areas SPA1, SPA2, and SPA3, and may expose a region of the first connecting line CNL1 in a corresponding one of the first, second, and third sub-pixel areas SPA1, SPA2, and SPA3. In an embodiment, the second via hole VIH2 may be positioned in each of the first, second, and third sub-pixel areas SPA1, SPA2, and SPA3, but the disclosure is not limited thereto.

The second via hole VIH2 of the first sub-pixel area SPA1 (or the first sub-pixel SPX1), the second via hole VIH2 of the third sub-pixel area SPA3 (or the third sub-pixel SPX3), and the second via hole VIH2 of the second sub-pixel area SPA2 (or the second sub-pixel SPX2) may overlap the first connecting line CNL1 in a plan view. For example, the second via holes VIH2 of the first to third sub-pixel areas SPA1, SPA2, and SPA3 (or the first to third sub-pixels SPX1, SPX2, and SPX3) may overlap different regions of the first connecting line CNL1 in a plan view. In an embodiment, the second via hole VIH2 of the first sub-pixel area SPA1, the second via hole VIH2 of the third sub-pixel area SPA3, and the second via hole VIH2 of the second sub-pixel area SPA2 are positioned on a same line (or are colinear with each other) in the second direction DR2. According to the invention, the second via hole VIH2 of the first sub-pixel area SPA1, the second via hole VIH2 of the third sub-pixel area SPA3, and the second via hole VIH2 of the second sub-pixel area SPA2 are positioned in a same column.

The third via hole VIH3 may be positioned in each of the first, second, and third sub-pixel areas SPA1, SPA2, and SPA3, and may expose a region of the second connecting line CNL2 in a corresponding one of the first, second, and third sub-pixel areas SPA1, SPA2, and SPA3. In an embodiment, the third via hole VIH3 may be positioned in each of the first, second, and third sub-pixel areas SPA1, SPA2, and SPA3.

The third via hole VIH3 of the first sub-pixel area SPA1 (or the first sub-pixel SPX1), the third via hole VIH3 of the third sub-pixel area SPA3 (or the third sub-pixel SPX3), and the third via hole VIH3 of the second sub-pixel area SPA2 (or the second sub-pixel SPX2) may overlap the second connecting line CNL2 in a plan view. The third via holes VIH3 of the first to third sub-pixel area SPA1, SPA2, and SPA3 (or the first to third sub-pixels SPX1, SPX2, and SPX3) may expose different regions of the second connecting line CNL2. In an embodiment, the third via hole VIH3 of the first sub-pixel area SPA1, the third via hole VIH3 of the third sub-pixel area SPA3, and the third via hole VIH3 of the second sub-pixel area SPA2 are positioned on a same line (or are colinear with each other) in the second direction DR2. According to the invention, the third via hole VIH3 of the first sub-pixel area SPA1, the third via hole VIH3 of the third sub-pixel area SPA3, and the third via hole VIH3 of the second sub-pixel area SPA2 are positioned in a same column.

In an embodiment, the first via hole VIH1 and the third via hole VIH3 may be spaced apart from each other in the first direction DR in each of the first, second, and third sub-pixel areas SPA1, SPA2, and SPA3, and may be positioned on a same line (or may be colinear with each other). For example, the first via hole VIH1 and the third via hole VIH3 may be positioned in a same row.

In an embodiment, the first via hole VIH1 (or the third via hole VIH3) and the second via hole VIH2 may be spaced apart from each other in the first direction DR1 in each of the first, second, and third sub-pixel areas SPA1, SPA2, and SPA3. Thus, the first via hole VIH1 (or the third via hole VIH3) and the second via hole VIH2 may be positioned in different rows.

The display element layer DPL including the light emitting element LD described with reference to FIG. 1 and FIG. 2 may be disposed on the pixel circuit layer PCL described above, and some of the display element layer DPL may be electrically connected to some of the pixel circuit layer PCL through the corresponding via hole. According to the invention, in the display element layer DPL of each of the first, second, and third sub-pixels SPX1, SPX2, and SPX3, the first alignment electrode ALE1 passes through the first via hole VIH1 to be electrically connected to the upper electrode of a corresponding one of the first, second, and third sub-pixels SPX1, SPX2, and SPX3.

Detailed description of electrical connections between the pixel circuit layer PCL and the display element layer DPL is provided below with reference to FIGS. 8 to 14.

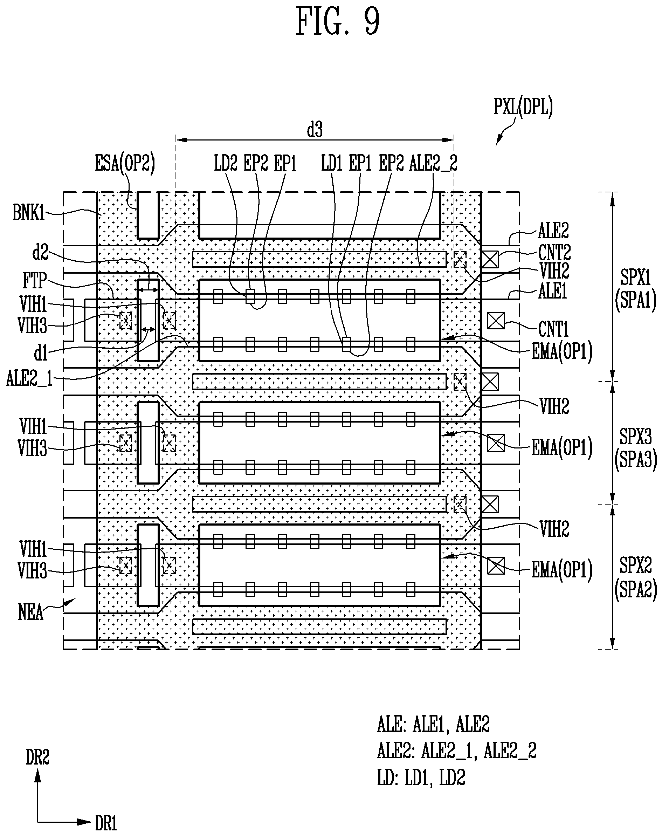

With reference to FIGS. 8 and 9, detailed description of components of the display element layer DPL of the pixel PXL is provided below.

FIG. 8 is a schematic plan view of the display element layer DPL of the pixel PXL according to an embodiment. FIG. 9 is a schematic plan view showing only the first and second alignment electrodes ALE1 and ALE2, the floating pattern FTP, the light emitting elements LD, and a first bank BNK1 that are included in the pixel PXL in FIG. 8.

In the embodiment in FIG. 8, the display element layer DPL of the pixel PXL may be positioned on the pixel circuit layer PCL of the pixel PXL in FIG. 5 and overlap the pixel circuit layer PCL in a plan view.

Referring to FIGS. 1 to 9, the display element layer DPL of the pixel PXL may include multiple emission components EMU that are disposed in the pixel area PXA. For example, the display element layer DPL may include a first emission component EMU1, a third emission component EMU3, and a second emission component EMU2, which are arranged in the second direction DR2. For example, the first emission component EMU1, the third emission component EMU3, and the second emission component EMU2 may be arranged in the second direction DR2 in sequence (or in a predetermined or selectable order). However, the disclosure is not limited thereto.

Each of the first, second, and third emission components EMU1, EMU2, and EMU3 may include light emitting elements LD electrically connected to the corresponding pixel circuit and emit light, and electrodes (or electrode patterns) electrically connected to the light emitting elements LD. For example, the first emission component EMU1 may include light emitting elements LD electrically connected to the first pixel circuit PXC1 and electrodes (or electrode patterns) electrically connected to the light emitting elements LD. The second emission component EMU2 may include light emitting elements LD electrically connected to the second pixel circuit PXC2 and electrodes (or electrode patterns) electrically connected to the light emitting elements LD. The third emission component EMU3 may include light emitting elements LD electrically connected to the third pixel circuit PXC3 and electrodes (or electrode patterns) electrically connected to the light emitting elements LD. The first pixel circuit PXC1 and the first emission component EMU1 may form the first sub-pixel SPX1. The second pixel circuit PXC2 and the second emission component EMU2 may form the second sub-pixel SPX2. The third pixel circuit PXC3 and the third emission component EMU3 may form the third sub-pixel SPX3.

Each of the first, second, and third sub-pixels SPX1, SPX2, and SPX3 may include an emission area EMA and a non-emission area NEA adjacent to (e.g., surrounding) at least one side of the emission area EMA.

The display element layer DPL may include a first bank BNK1 positioned in the non-emission area NEA.

The first bank BNK1 may be a pixel definition layer and define (or partition) the emission area EMA of each of the adjacent sub-pixels. For example, the first bank BNK1 may be a structure that defines the emission area EMA of each of the first, second, and third sub-pixels SPX1, SPX2, and SPX3. The first bank BNK1 may be a pixel definition layer or a dam structure that defines a space, in which the light emitting elements LD are supplied, in a process of supplying (or inputting) the light emitting elements LD to each of the first, second, and third sub-pixels SPX1, SPX2, and SPX3. For example, the emission area EMA of each of the first, second, and third sub-pixels SPX1, SPX2, and SPX3 may be partitioned (or defined) by the first bank BNK1, and a mixture solution (e.g., ink) including an amount (e.g., a desired amount) and/or kind of the light emitting elements LD may be supplied (or inputted) to the corresponding emission area EMA.

In some embodiments, the first bank BNK1 may be configured to include at least one light blocking material and/or a reflective material (or a scattering material) and prevent light leakage between the adjacent sub-pixels. In some embodiments, the first bank BNK1 may include a transparent material (or substance). The transparent material may include, for example, a polyamides resin, a polyimides resin, or the like, but the disclosure is not limited thereto. According to another embodiment, a reflective layer may also be separately provided and/or formed on the first bank BNK1 to further improve efficiency of the light emitted from each of first, second, and third sub-pixels SPXL1, SPXL2, and SPXL3.

The first bank BNK1 may include one or more openings OP1 and OP2 that expose some of the display element layer DPL. For example, the first bank BNK1 may include a first opening OP1 and a second opening OP2 that expose the components positioned below the first bank BNK1 in the display element layer DPL. In an embodiment, the emission area EMA of each of the first, second, and third sub-pixels SPX1, SPX2, and SPX3 may correspond to the first opening OP1 of the first bank BNK1. The second opening OP2 of the first bank BNK1 may be positioned in the non-emission area NEA.

The second opening OP2 of the first bank BNK1 may be spaced apart from the first opening OP1. The second opening OP2 may be an electrode separation area ESA in which the first alignment electrode ALE1 of each sub-pixel is separated from another first alignment electrode ALE1 provided in adjacent sub-pixel adjacent in the first direction DR1.

In an embodiment, the first bank BNK1 may be positioned on the first, second, and third via holes VIH1, VIH2, and VIH3 in the non-emission area NEA of each sub-pixel and completely cover the first, second, and third via holes VIH1, VIH2, and VIH3. Accordingly, the first, second, and third via holes VIH1, VIH2, and VIH3, which are connecting points of the pixel circuit layer PCL and the display element layer DPL, may be covered by the first bank BNK1. Thus, the first, second, and third via holes VIH1, VIH2, and VIH3 may not be exposed to the outside. As a result, when the light emitting elements LD are supplied to the emission area EMA of each sub-pixel SPX and aligned, in the region where the first, second, and third via holes VIH1, VIH2, and VIH3 are positioned, a flow velocity of the ink supplied to the emission area EMA may not increase. Thus, the light emitting elements LD may be prevented from being shifted and aligned to a region (or a specific region).

The display element layer DPL may include the electrode PE (or pixel electrode) provided in the emission area EMA of each of the first, second, and third sub-pixels SPX1, SPX2, and SPX3, the light emitting elements LD electrically connected to the electrode PE, and the alignment electrodes ALE provided at a position corresponding to the electrode PE. For example, the first electrode PE1 (or the first pixel electrode), the second electrode PE2 (or the second pixel electrode), the light emitting elements LD, the first and second alignment electrodes ALE1 and ALE2 may be disposed in the emission area EMA of each sub-pixel SPX. The intermediate electrode CTE may be disposed in the emission area EMA. The number, shape, size, and arrangement of each of the electrodes PE and/or the alignment electrodes ALE may be variously changed according to the structure of the first, second, and third sub-pixels SPX1, SPX2, and SPX3 (e.g., the first, second, and third emission components EMU1, EMU2, and EMU3).

The first emission component EMU1, the second emission component EMU2, and the third emission component EMU3 may have substantially a similar or identical structure. Detailed description of the first sub-pixel SPX1 including the first emission component EMU1 of the display element layer DPL is provided below.

In an embodiment, bank patterns BNP, the alignment electrodes ALE, the light emitting elements LD, and the electrodes PE may be sequentially disposed on a surface of the substrate SUB in which the first sub-pixel SPX1 is provided (or positioned), but the disclosure is not limited thereto. In some embodiments, the positions and formation orders of the electrodes forming the first sub-pixel SPX1 (or the first emission component EMU1) may be changed in various ways.

The bank patterns BNP (also referred to as a "support member", a "wall pattern", or a "wall structure") may be provided at least in the emission area EMA, and may extend in the first direction DR1 in the emission area EMA. The bank patterns BNP may be formed as separate patterns that are individually disposed under the alignment electrodes ALE and overlap the alignment electrodes ALE in a plan view. For example, the bank pattern BNP may be formed as separate patterns that are individually disposed under the first and second alignment electrodes ALE1 and ALE2.

The bank pattern BNP may be a structure that precisely defines an alignment position of the light emitting elements LD in the emission area EMA together with the alignment electrodes ALE. For example, the bank pattern BNP and the alignment electrodes ALE may precisely align the light emitting elements LD in the emission area EMA. The bank pattern BNP may guide the light reflected from the light emitting elements LD toward an image display direction of the display device.

The alignment electrode ALE may include the first alignment electrode ALE1 and the second alignment electrode ALE2 that are spaced apart from each other in the second direction DR2. In an embodiment, the first alignment electrode ALE1 and the second alignment electrode ALE2 may extend in the first direction DR1. For example, the first alignment electrode ALE1 and the second alignment electrode ALE2 may extend in the first direction DR1 intersecting the extending direction (e.g., the second direction DR2) of some elements (e.g., the first, second, and third data lines D1, D2, and D3) of the pixel circuit layer PCL.

In an embodiment, the first alignment electrode ALE1 may be separated from another electrode (e.g., the first alignment electrode ALE1 provided in the adjacent sub-pixel adjacent to the first sub-pixel SPX1 in the first direction DR1) after the light emitting elements LD are provided to the emission area EMA and aligned with the emission area EMA in a manufacturing process of the display device.

For example, the first alignment electrode ALE1 provided in the first sub-pixel SPX1 may be formed in the manufacturing process of the display device and electrically connected to the another first alignment electrode ALE1 provided to the adjacent sub-pixel adjacent to the first sub-pixel SPX1 in the first direction DR1. The first alignment electrodes ALE1 may be used as a first alignment line. For example, the first alignment electrode ALE1 and the floating pattern FTP may be integral with each other and form the first alignment line. The floating pattern FTP may be electrically connected to some element (e.g., the second connecting line CNL2) of the pixel circuit layer PCL through the third via hole VIH3. Accordingly, in the process of aligning the light emitting elements LD, a first alignment signal may be supplied to the first alignment line through the second connecting line CNL2 electrically connected to the first power line PL1. After the process of aligning the light emitting elements LD is completed, a portion of the first alignment line may be removed from the electrode separation area ESA (or the second opening OP2 of the first bank BNK1). Thus, the first alignment line may be disconnected. Accordingly, the first alignment electrodes ALE1 of the sub-pixels positioned in a same pixel row may be electrically separated (or disconnected) from each other. Thus, the sub-pixels may be independently driven. In an embodiment, a region of the insulating layers positioned between the floating pattern FTP and the second connecting line CNL2 may be removed, and the third via hole VIH3 may be formed.

The first alignment electrode ALE1 and the second alignment electrode ALE2 may extend in the first direction DR1 and may have a bar shape with a width (e.g., a predetermined or selectable width) in the second direction DR2, but the disclosure is not limited thereto. The first alignment electrode ALE1 and the second alignment electrode ALE2 may or may not have a curved portion at least in the non-emission area NEA, and the shape and/or size of the first alignment electrode ALE1 and the second alignment electrode ALE2 in the area other than the emission area EMA may not be limited and variously changed.

In an embodiment, the second alignment electrode ALE2 may include a (2-1)th alignment electrode ALE2_1 and a (2-2)th alignment electrode ALE2_2. The (2-1)th alignment electrode ALE2_1 and the (2-2)th alignment electrode ALE2_2 may be spaced apart from each other in the second direction DR2 and interpose the first alignment electrode ALE1 at least in the emission area EMA. The (2-1)th alignment electrode ALE2_1 and the (2-2)th alignment electrode ALE2_2 may be electrically connected to each other.

In a plan view, at least in the emission area EMA, the (2-1)th alignment electrode ALE2_1, the first alignment electrode ALE1, and the (2-2)th alignment electrode ALE2 2 may be arranged in the second direction DR2. The (2-1)th alignment electrode ALE2_1 may be positioned adjacent to a side (e.g., a lower side) of the first alignment electrode ALE1, and the (2-2)th alignment electrode ALE2_2 may be positioned adjacent to another side (e.g., an upper side) of the first alignment electrode ALE1. The first alignment electrode ALE1, the (2-1)th alignment electrode ALE2_1, and the (2-2)th alignment electrode ALE2_2 may be spaced apart from the alignment electrode ALE adjacent in the second direction DR2.

The second alignment electrode ALE2 may be electrically connected to some element (e.g., the first connecting line CNL1) of the pixel circuit layer PCL in the non-emission area NEA through the second via hole VIH2. For example, the second alignment electrode ALE2 of each of the first, second, and third sub-pixels SPX1, SPX2, and SPX3 may be electrically connected to the first connecting line CNL1 through the corresponding second via hole VIH2. Accordingly, in the process of aligning the light emitting elements LD, a second alignment signal may be supplied to the second alignment electrode ALE2 through the first connecting line CNL1. The first connecting line CNL1 and the second power line PL2 may be integral with each other.

The first alignment electrode ALE1 may be provided with the first alignment signal in the aligning of the light emitting elements LD. The second alignment electrode ALE2 may be provided with the second alignment signal in the aligning of the light emitting elements LD. The first and second alignment signals may be signals having a voltage difference and/or a phase difference sufficient to align the light emitting elements LD between the alignment electrodes ALE. At least one of the first and second alignment signals may be an alternate current signal, but the disclosure is not limited thereto. In an embodiment, the first alignment signal supplied to the first alignment electrode ALE1 may be an alternate current signal, and the second alignment signal supplied to the second alignment electrode ALE2 may be a ground voltage, but the disclosure is not limited thereto.

The floating pattern FTP spaced apart from the first and second alignment electrodes ALE1 and ALE2 may be disposed in the non-emission area NEA of each sub-pixel SPX. The floating pattern FTP may be spaced apart from the first alignment electrode ALE1 in the second opening OP2 (or the electrode separation area ESA) of the first bank BNK1 in a corresponding one of the first, second, and third sub-pixels SPX1, SPX2, and SPX3. The floating pattern FTP may be provided in an island shape and disposed between the first alignment electrodes ALE1 provided in the sub-pixels adjacent in the first direction DR1. For example, the floating pattern FTP in the non-emission area NEA of the first sub-pixel area SPA1 may be positioned between the first alignment electrode ALE1 of the first sub-pixel SPX1 and the adjacent first alignment electrode ALE1 provided in the adjacent sub-pixel positioned adjacent to the first sub-pixel SPX1 in the first direction DR1. The floating pattern FTP may be electrically connected to the second connecting line CNL2 through the third via hole VIH3, and may be electrically connected to the first alignment electrode ALE1 and may be used as the first alignment line together with the first alignment electrode ALE1 in the aligning of the light emitting elements LD. After aligning the light emitting elements LD, the floating pattern FTP may be electrically separated or disconnected from the first alignment electrode ALE1 in the electrode separation area ESA and may have the island shape.

The number of light emitting elements LD that may be aligned and/or provided in the emission area EMA may typically vary from at least two to tens. However, the number of the light emitting elements LD is not limited thereto. In some embodiments, the number of the light emitting elements LD aligned and/or provided in the emission area EMA may be changed in various ways.

The light emitting elements LD may be disposed between the first alignment electrode ALE1 and the second alignment electrode ALE2. In a plan view, each of the light emitting elements LD may include the first end EP1 and the second end EP2. For example, the first end EP1 and the second end EP2 may be positioned at opposite ends of the light emitting elements LD in the length direction (e.g., in the second direction DR2) thereof. The first end EP1 and the second end EP2 may face each other. In an embodiment, the second semiconductor layer 13 (e.g., refer to FIG. 1) including the p-type semiconductor layer may be positioned in the first end EP1, and the first semiconductor layer 11 (e.g., refer to FIG. 1) including the n-type semiconductor layer may be positioned in in the second end EP2. The light emitting elements LD may be electrically connected in a direction (e.g., in parallel with respect to each other) between the first alignment electrode ALE1 and second alignment electrode ALE2.

The light emitting elements LD may be separated from each other, and may be aligned in a direction (e.g., substantially in parallel to each other). An interval at which the light emitting elements LD are spaced apart is not limited thereto. In some embodiments, the light emitting elements LD may be arranged adjacent to each other to form a group, and other light emitting elements LD may be grouped and spaced apart from each other by an interval (e.g., a predetermined or selectable interval). Thus, the light emitting elements LD may have a non-uniform density and be aligned in a direction.

Each of the light emitting elements LD may emit any one of color light and/or white light. Each of the light emitting elements LD may be arranged between the first alignment electrode ALE1 and the second alignment electrode ALE2, and the length direction may be in a direction (e.g., parallel to the second direction DR2). The light emitting elements LD may be sprayed (or dispersed) in the solution (e.g., the mixture solution or the ink). Thus, the light emitting elements LD may be inputted (or supplied) to the emission area EMA.

The light emitting elements LD may be supplied to the pixel area (or the emission area EMA) of each sub-pixel through an inkjet printing method, a slit coating method, or various other methods. For example, the light emitting elements LD may be mixed with a volatile solvent and may be supplied to the emission area EMA by the inkjet printing method or the slit coating method. When the corresponding alignment signal is applied to each of the first alignment electrode ALE1 and the second alignment electrode ALE2, the light emitting elements LD may be aligned between the first alignment electrode ALE1 and the (2-1)th alignment electrode ALE2_1 and between the first alignment electrode ALE1 and the (2-2)th alignment electrode ALE2_2, respectively. After the light emitting elements LD are aligned, the solvent may be volatized or removed in other ways, and the light emitting elements LD may be stably aligned between the first alignment electrode ALE1 and the (2-1)th alignment electrode ALE2_1 and between the first alignment electrode ALE1 and the (2-2)th alignment electrode ALE2_2.

In an embodiment, the light emitting elements LD may include the first light emitting element LD1 and the second light emitting element LD2.

The first light emitting element LD1 may be aligned between a lower side of the first alignment electrode ALE1 and the (2-1)th alignment electrode ALE2_1 and electrically connected to the first electrode PE1 and the intermediate electrode CTE. The second light emitting element LD2 may be aligned between an upper side of the first alignment electrode ALE1 and the (2-2)th alignment electrode ALE2_2 and electrically connected to the intermediate electrode CTE and the second electrode PE2.

Multiple first light emitting elements LD1 and multiple second light emitting elements LD2 may be provided. A first end EP1 of each of the first light emitting elements LD1 may be electrically connected to the first electrode PE1, and a second end EP2 of each of the first light emitting elements LD1 may be electrically connected to the intermediate electrode CTE. A first end EP1 of each of the second light emitting elements LD2 may be electrically connected to the intermediate electrode CTE, and a second end EP2 of each of the second light emitting elements LD2 may be electrically connected to the second electrode PE2.

The first light emitting elements LD1 may be electrically connected in a direction (e.g., in parallel with respect to each other) between the first electrode PE1 and the intermediate electrode CTE, and the second light emitting elements LD2 may be electrically connected in a direction (e.g., in parallel with respect to each other) between the intermediate electrode CTE and the second electrode PE2.

In some embodiments, the first light emitting element LD1 and the second light emitting element LD2 may be an ultra-small light emitting element. For example, the size of the first light emitting element LD1 and the second light emitting element LD2 may be in a range of nano-scale (or nanometer) to micro-scale (or micrometer) and may use a material having an inorganic crystal structure.

The electrodes PE and the intermediate electrode CTE may be provided at least in the emission area EMA of each sub-pixel, and may be respectively provided in a position that corresponds to at least one alignment electrode ALE and the light emitting elements LD.

The first electrode PE1 (or the first pixel electrode) may be formed at the lower side of the first alignment electrode ALE1 and on the first end EP1 of each of the first light emitting elements LD1 and electrically connected to the first end EP1 of each of the first light emitting elements LD1. The first electrode PE1 may have a bar shape having a width (e.g., a predetermined or selectable width) in an extending direction (e.g., the first direction DR1) at least in the emission area EMA, but the disclosure is not limited thereto.

The second electrode PE2 (or the second pixel electrode) may be formed on the (2-2)th alignment electrode ALE2_2 and the second end EP2 of each of the second light emitting elements LD2 and electrically connected to the second end EP2 of each of the second light emitting elements LD. The second electrode PE2 may have a bar shape having a width (e.g., a predetermined or selectable width) in the extending direction (e.g., the first direction DR1) at least in the emission area EMA, but the disclosure is not limited thereto.

The intermediate electrode CTE may be formed on the (2-1)th alignment electrode ALE2_1 and the second end EP2 of each of the first light emitting elements LD1 and electrically connected to the second end EP2 of each of the first light emitting elements LD1. The intermediate electrode CTE may be formed on the upper side of the first alignment electrode ALE1 and the first end EP1 of each of the second light emitting elements LD2 and electrically connected to the first end EP1 of each of the second light emitting elements LD2. The intermediate electrode CTE may extend in the first direction DR1 at least in the emission area EMA. The intermediate electrode CTE may have a shape bent at least once in the non-emission area NEA and be adjacent to (e.g., surround) the first electrode PE1.

The first light emitting element LD1 may be electrically connected in series to the second light emitting element LD2 through the intermediate electrode CTE. The first electrode PE1, the intermediate electrode CTE, and the first light emitting elements LD1 may form the first serial stage SET1 of each of the first, second, and third emission components EMU1, EMU2, and EMU3. The first light emitting elements LD1 may be electrically connected between the first electrode PE1 and the intermediate electrode CTE. The intermediate electrode CTE, the second electrode PE2, and the second light emitting elements LD2 may form the second serial stage SET2 of the corresponding emission component. The second light emitting elements LD2 may be electrically connected between the intermediate electrode CTE and the second electrode PE2. The first electrode PE1 may be an anode of each of the first, second, and third emission components EMU1, EMU2, and EMU3, and the second electrode PE2 may be a cathode of the corresponding emission component.

In an embodiment, the first electrode PE1 of each of the first, second, and third sub-pixels SPX1, SPX2, and SPX3 may be electrically connected to the first alignment electrode ALE1 of a corresponding one of the first, second, and third sub-pixels SPX1, SPX2, and SPX3 through the first contact portion CNT1. The first alignment electrode ALE1 may be electrically connected to some of the corresponding pixel circuit PXC through the first via hole VIH1. For example, the first electrode PE1 of the first sub-pixel SPX1 may be electrically connected to the first upper electrode UE1 through the first contact portion CNT1, the first alignment electrode ALE1, and the first via hole VIH1 of the corresponding sub-pixel (e.g., the first sub-pixel SPX1). The first electrode PE1 of the second sub-pixel SPX2 may be electrically connected to the second upper electrode UE2 through the first contact portion CNT1, the first alignment electrode ALE1, and the first via hole VIH1 of the corresponding sub-pixel (e.g., the second sub-pixel SPX2). The first electrode PE1 of the third sub-pixel SPX3 may be electrically connected to the third upper electrode UE3 through the first contact portion CNT1, the first alignment electrode ALE1, and the first via hole VIH1 of the corresponding sub-pixel (e.g., the third sub-pixel SPX3). A region of the insulating layer positioned between the first electrode PE1 and the first alignment electrode ALE1 of each sub-pixel may be removed, and the first contact portion CNT1 of the corresponding one of the first, second, and third sub-pixels SPX1, SPX2, and SPX3 may be formed.

In an e embodiment, the second electrode PE2 of each of the first, second, and third sub-pixels SPX1, SPX2, and SPX3 may be electrically connected to the second alignment electrode ALE2 of a corresponding one of the first, second, and third sub-pixels SPX1, SPX2, and SPX3 through the second contact portion CNT2, and the second alignment electrode ALE2 may be electrically connected to some of the corresponding pixel circuit PXC through the second via hole VIH2. For example, the second electrode PE2 of the first sub-pixel SPX1 may be electrically connected to the first connecting line CNL1 through the second contact portion CNT2, the second alignment electrode ALE2, and the second via hole VIH2 of the corresponding sub-pixel (e.g., the first sub-pixel SPX1). The second electrode PE2 of the second sub-pixel SPX2 may be electrically connected to the first connecting line CNL1 through the second contact portion CNT2, the second alignment electrode ALE2, and the second via hole VIH2 of the corresponding sub-pixel (e.g., the second sub-pixel SPX2). The second electrode PE2 of the third sub-pixel SPX3 may be electrically connected to the first connecting line CNL1 through the second contact portion CNT2, the second alignment electrode ALE2, and the second via hole VIH2 of the corresponding sub-pixel (e.g., the third sub-pixel SPX3). A region of the insulating layer positioned between the second electrode PE2 and the second alignment electrode ALE2 of each sub-pixel may be removed, and the second contact portion CNT2 of the corresponding one of the first, second, and third sub-pixels SPX1, SPX2, and SPX3 may be formed.

The first electrode PE1 and the second electrode PE2 of each of the first, second, and third sub-pixels SPX1, SPX2, and SPX3 may be a driving electrode that drives the light emitting elements LD.

In each sub-pixel, during each frame period, a driving current may flow from the first electrode PE1 to the second electrode PE2 through the first light emitting element LD1, the intermediate electrode CTE, and the second light emitting element LD2.

According to the embodiment described above, the first via hole VIH1, which is a first connecting point connecting the pixel circuit PXC (or the pixel circuit layer PCL) and the emission component EMU (or the display element layer DPL) in each sub-pixel, and the adjacent first via hole VIH1 of the adjacent sub-pixel adjacent in the second direction DR2 may be positioned in the same column. For example, the first via hole VIH1 of the third sub-pixel SPX3 and the first via hole VIH1 of each of the first and second sub-pixels SPX1 and SPX2 that are adjacent in the second direction DR2 may be positioned in a same column. The first via holes VIH1 of the sub-pixels SPX1, SPX2, and SPX3 adjacent in the second direction DR2 may be positioned in the same column (or on the same line), and design constraints due to the position of the first via hole VIH1 in each sub-pixel may be reduced.

According to the embodiment described above, the second via hole VIH2, which is a second connecting point connecting the pixel circuit PXC (or the pixel circuit layer PCL) and the emission component EMU (or the display element layer DPL) in each sub-pixel, and the adjacent second via hole VIH2 of the adjacent sub-pixel adjacent in the second direction DR2 may be positioned in the same column. For example, the second via hole VIH2 of the third sub-pixel SPX3 and the second via hole VIH2 of each of the first and second sub-pixels SPX1 and SPX2 adjacent in the second direction DR2 may be positioned in a same column. The second via holes VIH2 of the sub-pixels SPX1, SPX2, and SPX3 adjacent in the second direction DR2 may be positioned in the same column (or on the same line), and design constraints due to the position of the second via hole VIH2 in each sub-pixel may be reduced.

According to the embodiment described above, the first via hole VIH1 and the third via hole VIH3 may be spaced apart from each other in the first direction DR1 by an interval d1 (e.g., a predetermined or selectable interval) and positioned in a same row (or positioned on a same line) in each sub-pixel, and the size of the electrode separation area ESA included to divide the first alignment line into the floating pattern FTP and the first alignment electrode ALE1 after aligning the light emitting elements LD may be reduced. For example, a width d2 of the electrode separation area ESA in the first direction DR1 may be smaller than a distance d1 between the first via hole VIH1 and the third via hole VIH3. Accordingly, design constraints due to the size of the electrode separation area ESA in each sub-pixel may be reduced to achieve design optimization of the electrode separation area ESA.

According to the embodiment described above, the first via hole VIH1 and the third via hole VIH3 may be positioned in a same row (or positioned on a same line) in the first direction DR1 in each sub-pixel, and the first alignment line formed by connecting the first alignment electrode ALE1 and the floating pattern FTP in a corresponding one of the first, second, and third sub-pixels SPX1, SPX2, and SPX3 may not be bent and may have a shape having a width (e.g., a predetermined or selectable width) in the extending direction (e.g., in the first direction DR1). Accordingly, the first alignment line may be designed to have an optimized shape in the aligning of the light emitting elements LD.

A distance d3 between the first via hole VIH1 and the second via hole VIH2 in each sub-pixel may determine the size of the emission area EMA of a corresponding one of the first, second, and third sub-pixels SPX1, SPX2, and SPX3. In the embodiment described above, the first via hole VIH1 of the first, second, and third sub-pixels SPX1, SPX2, and SPX3 may be positioned in the same direction as the arrangement direction of the storage capacitor Cst of the corresponding one of the first, second, and third sub-pixels SPX1, SPX2, and SPX3. The second via hole VIH2 of the first, second, and third sub-pixels SPX1, SPX2, and SPX3 may be positioned in the same direction as the extending direction of the first connecting line CNL1 of the corresponding one of the first, second, and third sub-pixels SPX1, SPX2, and SPX3. The distance d3 between the first via hole VIH1 and the second via hole VIH2 of each sub-pixel in the first direction DR1 may be further secured. Accordingly, the size (or the area) of the emission area of each sub-pixel EMA may increase, and the amount of ink supplied to the corresponding one of the first, second, and third sub-pixels SPX1, SPX2, and SPX3 may further increase. Accordingly, an effective light source of each sub-pixel may be further secured, and emission efficiency of the corresponding one of the first, second, and third sub-pixels SPX1, SPX2, and SPX3 may further be improved.

According to the embodiment described above, the size of the emission area of each sub-pixel EMA increases, and the amount of ink injected into the emission area EMA may increase. Thus, the concentration of the light emitting elements LD dispersed in the ink may be decreased. For example, the inkjet printing device or the like may supply the ink to the emission area EMA by a concentration gradient of the light emitting elements LD in the ink. A defect of a clogged nozzle due to an unsmooth flow of the ink, which is caused by the agglomeration of the light emitting elements LD in the nozzle of the inkjet printing device may be decreased or removed.

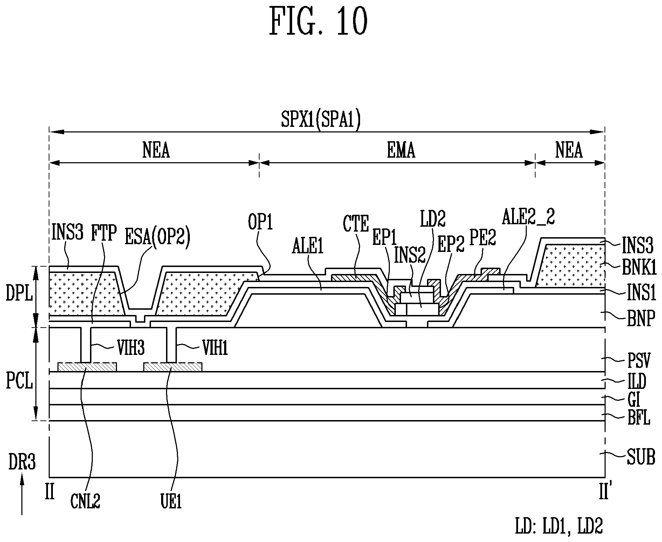

Detailed description of a laminated structure of the pixel according to an embodiment PXL is provided below with reference to FIGS. 10 to 14.

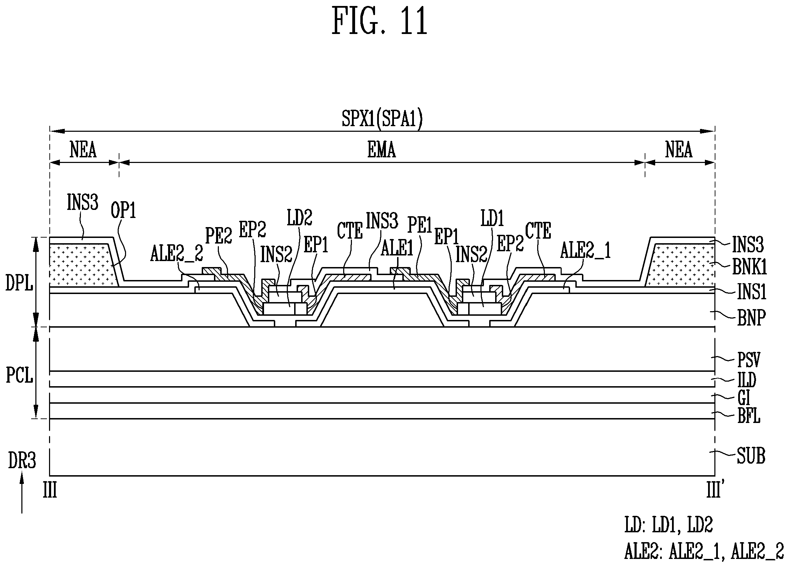

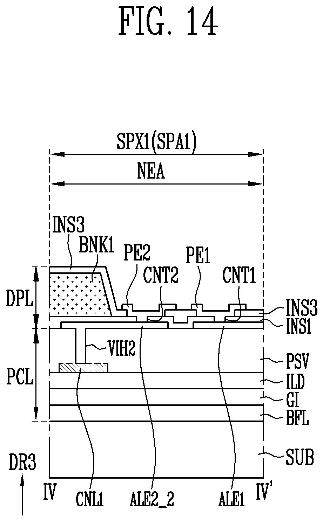

FIG. 10 is a schematic cross-sectional view of FIG. 8 taken along line II- II'. FIGS. 11 to 13 are schematic cross-sectional views of FIG. 8 taken along line III -III'. FIG. 14 is a schematic cross-sectional view of FIG. 8 taken along line IV -IV'.

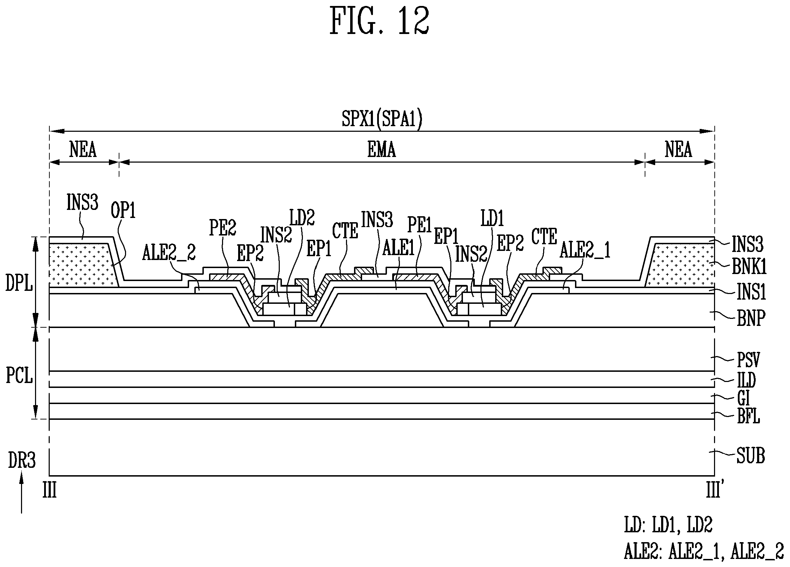

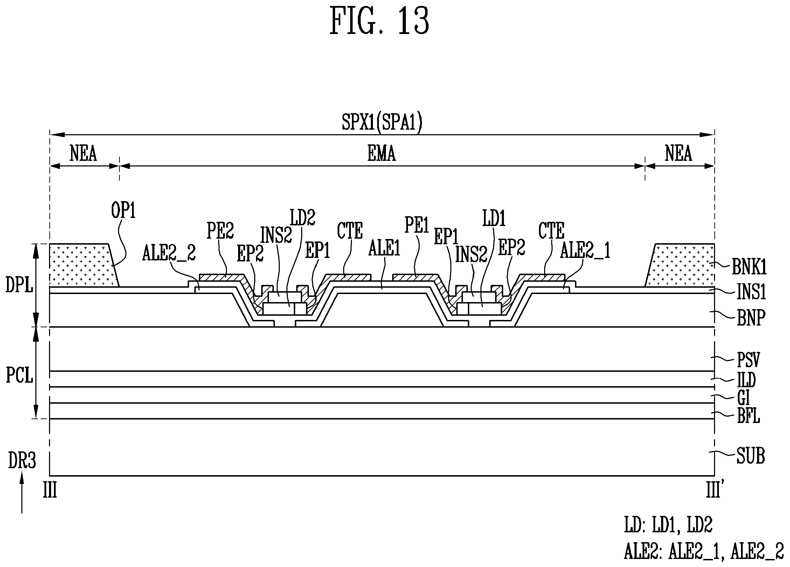

The embodiments of FIG. 12 and FIG. 13 show variations of the embodiment of FIG. 11 with respect to forming the electrode PE and the intermediate electrode CTE. In FIG. 13, the third insulating layer INS3 may be omitted. For example, in FIG. 12, the intermediate electrode CTE may be formed after forming the first and second electrodes PE1 and PE2 and the third insulating layer INS3. In FIG. 13, the first and second electrodes PE1 and PE2 and the intermediate electrode CTE may be formed by a same process.

In FIGS. 10 to 14, the pixels PXL are simplified, each electrode may have a single layer, and each insulating layer may have a single layer, but the disclosure is not limited thereto.

With respect to the embodiments of FIGS. 10 to 14, detailed description of the same constituent elements is omitted.

Referring to FIG. 1 to FIG. 14, the pixel PXL may include the substrate SUB, the pixel circuit layer PCL, and the display element layer DPL.

The pixel circuit layer PCL and the display element layer DPL may overlap each other on the surface of the substrate SUB in a plan view. For example, the pixel area PXA of the substrate SUB may include the pixel circuit layer PCL and the display element layer DPL. The pixel circuit layer PCL may be disposed on the surface of the substrate SUB, and the display element layer DPL may be disposed on the pixel circuit layer PCL. The pixel circuit layer PCL may include the buffer layer BFL, the gate insulating layer GI, the interlayer insulating layer ILD, and the passivation layer PSV. The buffer layer BFL, the gate insulating layer GI, the interlayer insulating layer ILD, and the passivation layer PSV may be sequentially laminated on the substrate SUB. Since the pixel circuit layer PCL is the same as the pixel circuit layer PCL described with reference to FIGS. 5 to 7, detailed description thereof is omitted.

The display element layer DPL may include the first and second alignment electrodes ALE1 and ALE2, the light emitting elements LD, the intermediate electrode CTE, and the first and second electrodes PE1 and PE2. The display element layer DPL may further include insulating patterns and/or an insulating layer that are sequentially disposed on a surface of the pixel circuit layer PCL. For example, the display element layer DPL may further include the bank pattern BNP, a first insulating layer INS1, the first bank BNK1, a second insulating layer INS2, and the third insulating layer INS3.

The bank pattern BNP may protrude on the surface of the pixel circuit layer PCL (or the passivation layer PSV) in a third direction DR3. Accordingly, a region of each of the first and second alignment electrodes ALE1 and ALE2 disposed on the bank pattern BNP may protrude in the third direction DR3 (or a thickness direction of the substrate SUB).

The bank pattern BNP may be an inorganic layer including an inorganic material or an organic layer including an organic material. In some embodiments, the bank pattern BNP may include an organic layer having a single layer and/or an inorganic layer having a single layer, but the disclosure is not limited thereto. In some embodiments, the bank pattern BNP may be provided as multiple layers in which at least one organic layer and at least one inorganic layer are laminated. However, the materials of the bank pattern BNP are not limited to the embodiment described above, but in some embodiments, the bank pattern BNP may also include a conductive material (or a substance). The shape of the bank pattern BNP may be variously changed in a range that may improve efficiency of the light emitted from the light emitting element LD.

The bank pattern BNP may be used as a reflective member. For example, the bank pattern BNP may direct (or guide) the light emitted from the light emitting element LD in a direction (e.g., a desired direction) together with the first alignment electrode ALE1 and the second alignment electrode ALE2 disposed on the bank pattern BNP. For example, the bank pattern BNP, the first alignment electrode ALE1, and the second alignment electrode ALE2 may guide the light emitted from the light emitting element LD in the direction. The bank pattern BNP may be used as a reflective member for improving emission efficiency of each of the first, second, and third sub-pixels SPX1, SPX2, and SPX3.

The first alignment electrode ALE1 and the second alignment electrode ALE2 may be provided and/or formed on the bank pattern BNP.

The first alignment electrode ALE1 and the second alignment electrode ALE2 may be provided and/or formed on the pixel circuit layer PCL (or the passivation layer PSV) and the bank pattern BNP.

The first alignment electrode ALE1 and the second alignment electrode ALE2 may be spaced apart from each other. The first alignment electrode ALE1 and the second alignment electrode ALE2 may be disposed on a same plane, and may have a same thickness in the third direction DR3. The first alignment electrode ALE1 and the second alignment electrode ALE2 may be simultaneously formed or sequentially formed in a same process. Each of the first alignment electrode ALE1 and the second alignment electrode ALE2 may have a shape corresponding to a profile of the bank pattern BNP positioned thereunder.

The first alignment electrode ALE1 and the second alignment electrode ALE2 may be made of a material having a reflectance (or a predetermined or selectable reflectance) and the light reflected from the light emitting element LD may travel in an image display direction of the display device. For example, the first alignment electrode ALE1 and the second alignment electrode ALE2 may be made of a conductive material (or substance). The conductive material may include an opaque metal suitable for reflecting the light reflected from the light emitting elements LD in the image display direction (or in an upper direction of the display element layer DPL) of the display device. The opaque metal of the first and second alignment electrodes ALE1 and ALE2 may include, for example, at least one metal of silver (Ag), magnesium (Mg), aluminum (Al), platinum (Pt), palladium (Pd), gold (Au), nickel (Ni), neodymium (Nd), iridium (Ir), chromium (Cr), and titanium (Ti). For example, the opaque metal of the first and second alignment electrodes ALE1 and ALE2 may include an alloy thereof. However, the materials of the first alignment electrode ALE1 and the second alignment electrode ALE2 are not limited to the embodiment described above. In some embodiments, the first alignment electrode ALE1 and the second alignment electrode ALE2 may include a transparent conductive material (or substance). The transparent conductive material (or substance) of the first and second alignment electrodes ALE1 and ALE2 may include at least one conductive oxide of an indium tin oxide (ITO), an indium zinc oxide (IZO), a zinc oxide (ZnOₓ), an indium gallium zinc oxide (IGZO), and indium tin zinc oxide (ITZO). For example, the transparent conductive material (or substance) of the first and second alignment electrodes ALE1 and ALE2 may include a conductive polymer such as poly(3,4-ethylenedioxythiophene (PEDOT). When the first alignment electrode ALE1 and the second alignment electrode ALE2 includes a transparent conductive material (or substance), a separate conductive layer made of an opaque metal may be added and the light reflected from the light emitting elements LD may be reflected in the image display direction of the display device. However, the materials of the first alignment electrode ALE1 and the second alignment electrode ALE2 are not limited to the materials described above.

The first alignment electrode ALE1 and the second alignment electrode ALE2 may be provided and/or formed as a single layer, but the disclosure is not limited thereto. In some embodiments, the first alignment electrode ALE1 and the second alignment electrode ALE2 may also be provided and/or formed as multiple layers in which at least two of metals, alloys, conductive oxides, and conductive polymers are laminated. The first alignment electrode ALE1 and the second alignment electrode ALE2 may also be formed as multiple layers having at least two layers and minimize distortion due to a signal delay, which is caused by transmission of a signal to the first end EP1 and the second end EP2 of the light emitting elements LD.

When the first alignment electrode ALE1 and the second alignment electrode ALE2 are formed of a conductive material having reflectance, the light reflected from the first and second ends EP1 and EP2 of each of the light emitting elements LD may further progress in the image display direction of the display device. For example, when the first alignment electrode ALE1 and the second alignment electrode ALE2 have an inclined surface or a curved surface corresponding to the shape of the bank pattern BNP and face the first and second ends EP1 and EP2 of each of the light emitting elements LD, the light emitted from the first and second ends EP1 and EP2 of each of the light emitting elements LD may be reflected by the first alignment electrode ALE1 and the second alignment electrode ALE2 to further progress in the image display direction of the display device. Accordingly, efficiency of the light emitted from the light emitting elements LD may be improved.

In an embodiment, at least one first alignment electrode ALE1 and at least one second alignment electrode ALE2 may be disposed in the emission area EMA of each sub-pixel. For example, the first alignment electrode ALE1 may be disposed at a center of the emission area EMA, the (2-1)th alignment electrode ALE2_1 may be disposed at a lower side of the first alignment electrode ALE1, and the (2-2)th alignment electrode ALE2_2 may be disposed at an upper side of the first alignment electrode ALE1. The (2-1)th alignment electrode ALE2_1 and the (2-2)th alignment electrode ALE2_2 may be integral with each other. In other embodiments, the (2-1)th alignment electrode ALE2_1 and the (2-2)th alignment electrode ALE2_2 may not be integral with each other. The (2-1)th alignment electrode ALE2_1 and the (2-2)th alignment electrode ALE2_2 may be supplied with a same signal or power source.

In each sub-pixel, the first alignment electrode ALE1 may be electrically connected to the upper electrode of the corresponding one of the first, second, and third sub-pixels SPX1, SPX2, and SPX3 through the corresponding first via hole VIH1. For example, the first alignment electrode ALE1 may be electrically connected to the first upper electrode UE1 through the corresponding first via hole VIH1 in the first sub-pixel SPX1. The first alignment electrode ALE1 may be electrically connected to the first electrode PE1 through the corresponding first contact portion CNT1 at least in the non-emission area NEA.

In each sub-pixel, the second alignment electrode ALE2 may be electrically connected to the first connecting line CNL1 (or a second power line PL2) of the corresponding one of the first, second, and third sub-pixels SPX1, SPX2, and SPX3 through the corresponding second via hole VIH2. For example, the second alignment electrode ALE2 may be electrically connected to the first connecting line CNL1 through the corresponding second via hole VIH2 in the first sub-pixel SPX1. The second alignment electrode ALE2 may be electrically connected to the second electrode PE2 through the corresponding second contact portion CNT2 at least in the non-emission area NEA.

In the electrode separation area ESA of each sub-pixel, the floating pattern FTP may be disposed to be spaced apart from the first alignment electrode ALE1 and electrically connected to the second connecting line CNL2 (or the first power line PL1) of the corresponding one of the first, second, and third sub-pixels SPX1, SPX2, and SPX3 through the corresponding through the third via hole VIH3.

The first insulating layer INS1 may be disposed on the first alignment electrode ALE1, the second alignment electrode ALE2, and the floating pattern FTP.

The first insulating layer INS1 may be provided and/or formed on the first alignment electrode ALE1, the second alignment electrode ALE2, and the floating pattern FTP. The first insulating layer INS1 may be partially opened to expose components positioned thereunder in the non-emission area NEA. For example, the first insulating layer INS1 may be partially opened to include the first contact portion CNT1 and the second contact portion CNT2. The first contact portion CNT1 may expose a region of the first alignment electrode ALE1, and the second contact portion CNT2 may expose a region of the second alignment electrode ALE2.

The first insulating layer INS1 may be formed as an inorganic insulating layer made of an inorganic material. For example, the first insulating layer INS1 may include at least one of a silicon nitride (SiNₓ), a silicon oxide (SiOₓ), a silicon oxynitride (SiOₓN_{y}), and an aluminum oxide (AlOₓ).

In some embodiments, the first insulating layer INS1 may be provided as a single layer or multiple layers. When the first insulating layer INS1 is provided as multiple layers, the first insulating layer INS1 may have a distributed Bragg reflectors structure in which a first layer and a second layer formed by an inorganic layer and having different refractive indexes are alternately laminated.

The first bank BNK1 may disposed on the first insulating layer INS1.

The first bank BNK1 may be provided and/or formed on the first insulating layer INS1 in the non-emission area NEA. The first bank BNK1 may be adjacent to (e.g., surround) the emission area of each sub-pixel EMA, and may be formed between the adjacent sub-pixels and form a pixel definition layer partitioning the emission area EMA of the corresponding one of the first, second, and third sub-pixels SPX1, SPX2, and SPX3. In the supplying of the light emitting elements LD to the emission area EMA, the first bank BNK1 may prevent the solution (or the ink) mixed with the light emitting elements LD from flowing into the adjacent emission area EMA of the adjacent sub-pixel or may control an appropriate amount of the solution to be supplied to each emission area EMA.

In some embodiments, the first bank BNK1 may be surface-treated, and at least one surface thereof may have a hydrophobic property (or liquid repellency). For example, the first bank BNK1 may be surface-treated and have a hydrophobic property by plasma before aligning the light emitting elements LD, but the disclosure is not limited thereto.

The light emitting elements LD may be supplied to the emission area of each sub-pixel EMA adjacent to (e.g., surrounded by) the first bank BNK1. For example, the light emitting elements LD may be supplied to the emission area EMA through the inkjet printing method or the like, and the light emitting elements LD may be aligned on a surface of the first insulating layer INS1 between the first alignment electrode ALE1 and the second alignment electrode ALE2 by an electric field generated by a signal (or an alignment signal) respectively applied to the first alignment electrode ALE1 (or the first alignment line before separation into the first alignment electrode ALE1) and the second alignment electrode ALE2. For example, the light emitting elements LD supplied to the emission area EMA may be arranged. Thus, the first ends EP1 may be directed toward the first alignment electrode ALE1 and the second ends EP2 may be directed toward the second alignment electrodes ALE2.

The light emitting elements LD may include a first light emitting element LD1 and a second light emitting element LD2.

The first light emitting element LD1 may be arranged between a side of the first alignment electrode ALE1 (e.g., a lower side on a plane) and the (2-1)th alignment electrode ALE2_1. The first light emitting element LD1 may include the first end EP1 facing the first alignment electrode ALE1, and the second end EP2 facing the (2-1)th alignment electrode ALE2_1.

The second light emitting element LD2 may be arranged between another side (e.g., an upper side on the plane) of the first alignment electrode ALE1 and the (2-2)th alignment electrode ALE2_2. The second light emitting element LD2 may include the first end EP1 facing the first alignment electrode ALE1, and the second end EP2 facing the (2-2)th alignment electrode ALE2_2.

The second insulating layer INS2 (or an insulating pattern) may be respectively disposed on the first and second light emitting elements LD1 and LD2. The second insulating layer INS2 may be positioned on the first and second light emitting elements LD1 and LD2 and partially cover an external circumferential surface (or a surface) of each of the first and second light emitting elements LD1 and LD2. Thus, the first end EP1 and the second end EP2 of each of the first and second light emitting elements LD1 and LD2 may be exposed to the outside.

The second insulating layer INS2 may include an inorganic insulating layer including an inorganic material or an organic insulating layer including an organic material. For example, the second insulating layer INS2 may include an inorganic insulating layer suitable for protecting the active layer 12 of each of the first and second light emitting elements LD1 and LD2 from external oxygen and moisture, but the disclosure is not limited thereto, and depending on a design condition of the display device to which the first and second light emitting elements LD1 and LD2 are applied, the second insulating layer INS2 may also be formed as the organic insulating layer including the organic material. The second insulating layer INS2 may be formed as a single layer or multiple layers.

When a gap (or space) exists between the first insulating layer INS1 and the light emitting elements LD before forming the second insulating layer INS2, the gap may be filled with the second insulating layer INS2 in the process of forming the second insulating layer INS2.

By forming the second insulating layer INS2 on the first and second light emitting elements LD1 and LD2 that are completely aligned in the emission area EMA of each of the first, second, and third sub-pixels SPX1, SPX2, and SPX3, the first and second light emitting elements LD1 and LD2 may be prevented from being separated from the aligned positions.

On the first and second ends EP1 and EP2 of each of the first and second light emitting elements LD1 and LD2 that are not covered by the second insulating layer INS2, different electrodes of the first electrode PE1, the second electrode PE2, and the intermediate electrode CTE may be formed. For example, the first electrode PE1 may be formed on the first end EP1 of the first light emitting element LD1. The intermediate electrode CTE may be formed on the second end EP2 of the first light emitting element LD1. The intermediate electrode CTE may be formed on the first end EP1 of the second light emitting element LD2. The second electrode PE2 may be formed on the second end EP2 of the second light emitting element LD2.

The first electrode PE1 may be disposed on the first alignment electrode ALE1 and overlap a side of the first alignment electrode ALE1 in a plan view. The second electrode PE2 may be disposed under the (2-2)th alignment electrode ALE2_2 and overlap the (2-2)th alignment electrode ALE2_2 in a plan view. The intermediate electrode CTE may be disposed on each of the first alignment electrode ALE1 and the (2-1)th alignment electrode ALE2_1 and overlap another side of the first alignment electrode ALE1 and (2-1)th alignment electrode ALE2_1 in a plan view.

In an embodiment, the first electrode PE1, the intermediate electrode CTE, and the second electrode PE2 may be disposed on a same layer or different layers. For example, relative positions and/or a formation sequence of the first electrode PE1, the intermediate electrode CTE, and the second electrode PE2 may be changed in various ways according to embodiments.

In the embodiment of FIG. 11, the intermediate electrode CTE may be formed on (e.g., formed firstly on) the second insulating layer INS2. The intermediate electrode CTE may contact (e.g., directly contact) the second end EP2 of the first light emitting element LD1 and the first end EP1 of the second light emitting element LD2, and be electrically connected between the first light emitting element LD1 and the second light emitting element LD2. The third insulating layer INS3 may be formed in the emission area EMA and cover the intermediate electrode CTE.

The third insulating layer INS3 may be positioned on the intermediate electrode CTE and cover the intermediate electrode CTE (or prevent the intermediate electrode CTE from being exposed to the outside). Thus, corrosion of the intermediate electrode CTE may be prevented.

The third insulating layer INS3 may include an inorganic insulating layer made of an inorganic material, or an organic insulating layer made of an organic material. For example, the third insulating layer INS3 may include at least one of a silicon nitride (SiNₓ), a silicon oxide (SiOₓ), a silicon oxynitride (SiOₓN_{y}), and an aluminum oxide (AlOₓ), but the disclosure is not limited thereto. The third insulating layer INS3 may be formed as a single layer or multiple layers.

The first electrode PE1 and the second electrode PE2 may be formed on the third insulating layer INS3. The first electrode PE1 may contact (e.g., directly contact) the first end EP1 of the first light emitting element LD1. The second electrode PE2 may contact (e.g., directly contact) the second end EP2 of the second light emitting element LD2.

In the embodiment of FIG. 12, the first and second electrodes PE1 and PE2 may be formed on (e.g., formed firstly on) the second insulating layer INS2. The first and second electrodes PE1 and PE2 may be simultaneously or sequentially formed. The third insulating layer INS3 may cover the first and second electrodes PE1 and PE2, and the intermediate electrode CTE may be formed in the emission area EMA in which the third insulating layer INS3 is formed.

As in the embodiments of FIGS. 11 and 12, when the electrodes disposed on the first end EP1 and the second end EP2 of each light emitting element LD are disposed on different layers, the electrodes may be stably electrically separated or disconnected to prevent a short circuit between the electrodes.

In the embodiment of FIG. 13, the first electrode PE1, the intermediate electrode CTE, the second electrode PE2, and the display element layer DPL may be disposed on a same layer, and the first electrode PE1, the intermediate electrode CTE, and the second electrode PE2 may be simultaneously or sequentially formed. The third insulating layer INS3 may be omitted. In the embodiment of FIG. 13, when the electrodes disposed on the first end EP1 and the second end EP2 of each of the first and second light emitting elements LD1 and LD2 are disposed on a same layer and are simultaneously formed, a manufacturing process of each sub-pixel may be simplified and process efficiency may be improved.

The first electrode PE1, the second electrode PE2, and the intermediate electrode CTE may be made of various transparent conductive materials, and the light emitted from each of the light emitting elements LD may travel (or be guided) in the image display direction of the display device (e.g., the third direction DR3) without loss. For example, the first electrode PE1, the second electrode PE2, and the intermediate electrode CTE may include at least one of various transparent conductive materials (or substances) including at least one of an indium tin oxide (ITO), an indium zinc oxide (IZO), a zinc oxide (ZnOₓ), an indium gallium zinc oxide (IGZO), and an indium tin zinc oxide (ITZO). For example, the first electrode PE1, the second electrode PE2, and the intermediate electrode CTE may be substantially transparent or translucent and satisfy a transmittance (e.g., a predetermined transmittance). However, the materials of the first electrode PE1, the second electrode PE2, and the intermediate electrode CTE are not limited to the embodiment described above. In some embodiments, the first electrode PE1, the second electrode PE2, and the intermediate electrode CTE may also be formed of various non-transparent conductive materials (or substances). The first electrode PE1, the second electrode PE2, and the intermediate electrode CTE may be formed as a single layer or multiple layers.

In some embodiments, at least one overcoat layer (e.g., a layer for planarizing a top surface of the display element layer DPL) may be further disposed on the first electrode PE1, the intermediate electrode CTE, and the second electrode PE2.

According to another embodiment, an optical layer may be selectively disposed on the display element layer DPL of each sub-pixel (or each pixel PXL). For example, the optical layer may include a color conversion layer including color conversion particles that convert the light reflected from the light emitting elements LD into light of a color (e.g., a specific color).

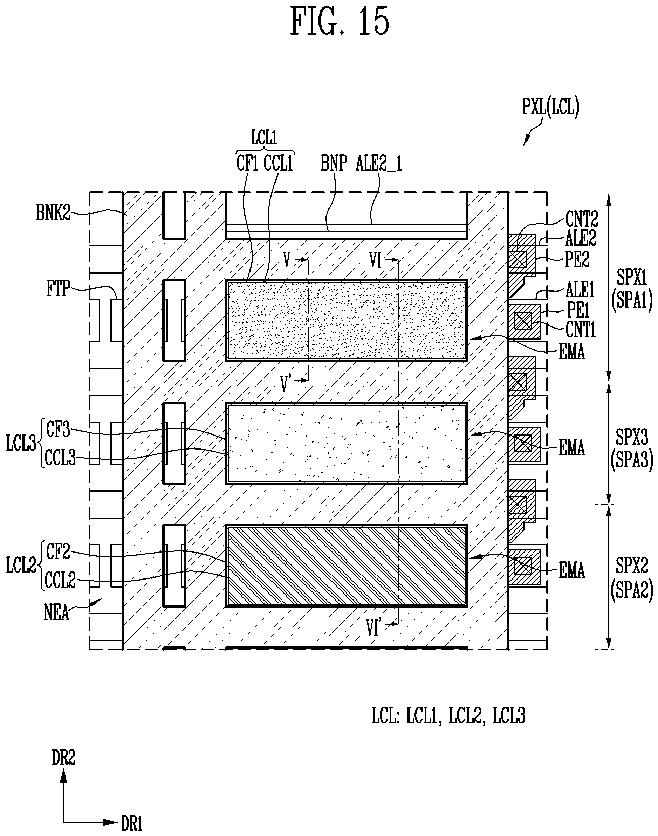

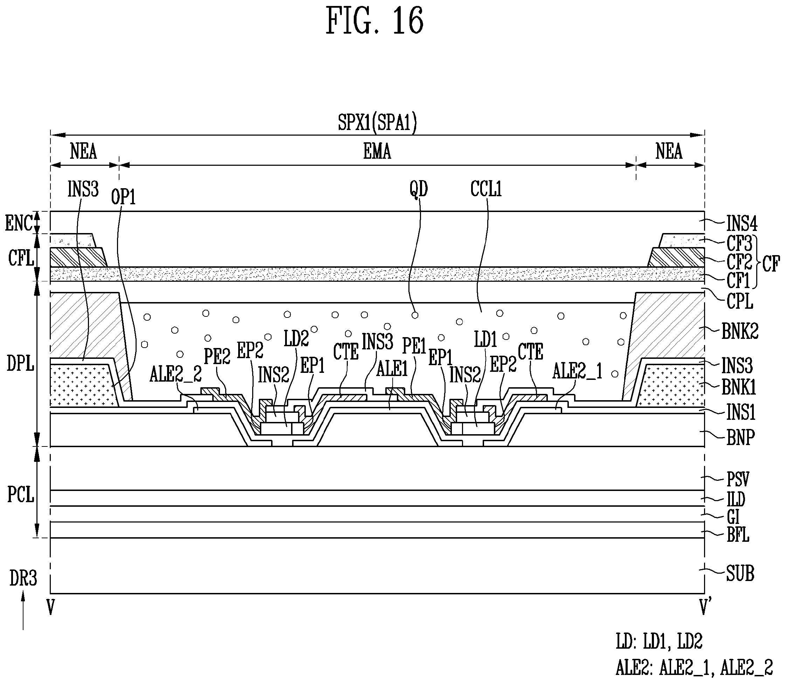

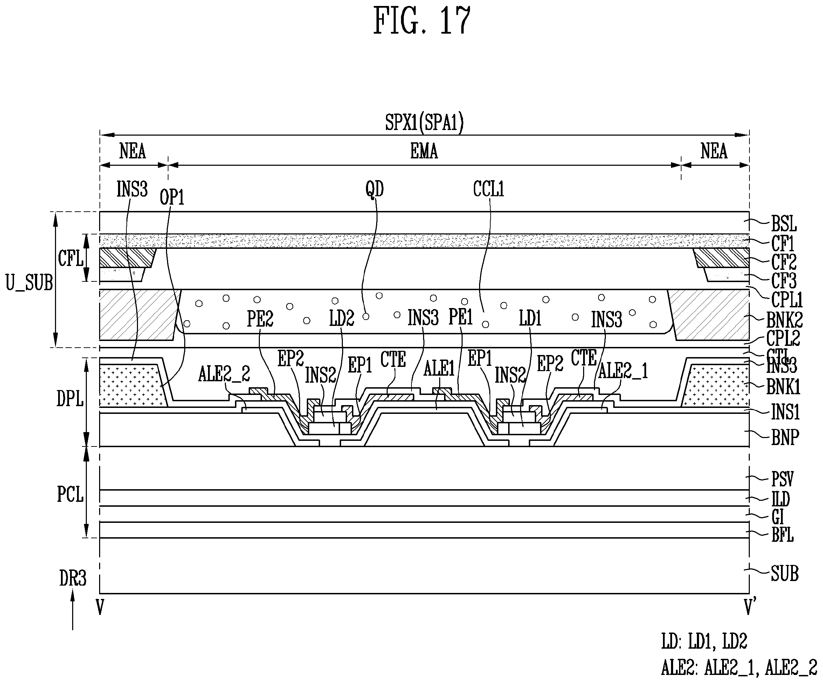

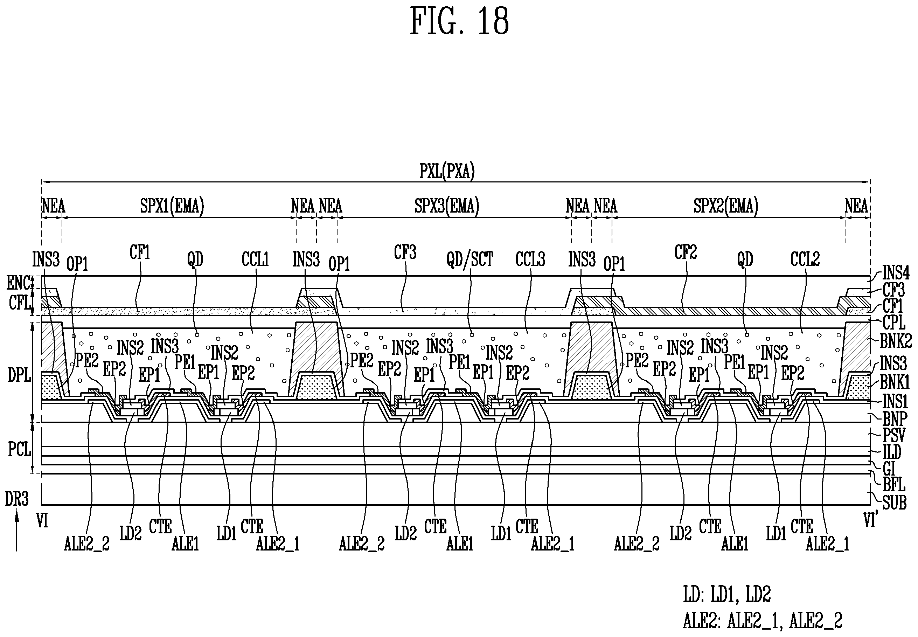

FIG. 15 is a schematic plan view of an optical layer LCL of a pixel PXL according to an embodiment. FIGS. 16 and 17 are schematic cross-sectional views of FIG. 15 taken along line V-V'. FIG. 18 is a schematic cross-sectional view of FIG. 15 taken along line VI - VI'.

In the embodiment of FIG. 15, the optical layer LCL of the pixel PXL may be positioned on the display element layer DPL of the pixel PXL in FIG. 8 and overlap the display element layer DPL in a plan view.

The embodiments in FIGS. 16 and 17 show different variations with respect to a position of a first color conversion layer CCL1. For example, in FIG. 16, the first color conversion layer CCL1 and the first color filter CF1 are positioned on the first and second electrodes PE1 and PE2 by continuous processes. In FIG. 17, an upper substrate U_SUB including a first color conversion layer CCL1 and a first color filter CF1 are positioned on the display element layer DPL through an adhering process using an intermediate layer CTL.

With respect to the embodiments of FIGS. 15 to 18, to avoid repeated description, detailed description of the same constituent elements is omitted.

Referring to FIGS. 1 to 18, an optical layer LCL of a pixel PXL may include a first optical layer LCL1 positioned in an emission area EMA of a first sub-pixel SPX1, a second optical layer LCL2 positioned in an emission area EMA of a second sub-pixel SPX2, and a third optical layer LCL3 positioned in an emission area EMA of a third sub-pixel SPX3. The first optical layer LCL1, the third optical layer LCL3, and the second optical layer LCL2 may be positioned in a second direction DR2. The first optical layer LCL1 may include a first color conversion layer CCL1 and a first color filter CF1 that overlap each other in a plan view. The second optical layer LCL2 may include a second color conversion layer CCL2 and a second color filter CF2 that overlap each other in a plan view. The third optical layer LCL3 may include a third color conversion layer CCL3 and a third color filter CF3 that overlap each other in a plan view.

In an embodiment, a second bank BNK2 may be positioned in a non-emission area NEA of each of the first, second, and third sub-pixels SPX1, SPX2, and SPX3.

The second bank BNK2 may be provided and/or formed on the first bank BNK1. The second bank BNK2 may be adjacent to (e.g., surround) the emission area EMA of each of the first, second, and third sub-pixels SPX1, SPX2, and SPX3. The second bank BNK2 may define the position of each of the first, second, and third color conversion layers CCL1, CCL2, and CCL3 and may be a dam structure that finally defines the emission area EMA. For example, the second bank BNK2 may define a position to which the first color conversion layer CCL1 is supplied (or inputted) in the first sub-pixel SPX1, a position to which the second color conversion layer CCL2 is supplied (or inputted) in the second sub-pixel SPX2, and a position to which the third color conversion layer CCL3 is supplied (or inputted) in the third sub-pixel SPX3. The second bank BNK2 may be a dam structure that finally defines (or partitions) the emission area EMA of each of the first, second, and third sub-pixels SPX1, SPX2, and SPX3.

The second bank BNK2 may include a light blocking material. For example, the second bank BNK2 may be a black matrix. In some embodiments, the second bank BNK2 may include at least one light blocking material and/or at least one reflective material. Thus, the light reflected from the first, second, and third color conversion layers CCL1, CCL2, and CCL3 may further travel in the image display direction of the display device (or the third direction DR3). Therefore, emission efficiency of each of the first, second, and third color conversion layers CCL1, CCL2, and CCL3 may be improved.

Each of the first, second, and third color conversion layers CCL1, CCL2, and CCL3 may be formed on the first electrode PE1, the intermediate electrode CTE, and the second electrode PE2 of each sub-pixel within the emission area EMA adjacent to (e.g., surrounded by) the second bank BNK2.

Each of the first, second, and third color conversion layers CCL1, CCL2, and CCL3 may include color-converting particles QD corresponding to a color (e.g., a specific color). For example, each of the first, second, and third color conversion layers CCL1, CCL2, and CCL3 may include color-converting particles QD converting light of a first color emitted from each of the first and second light emitting elements LD1 and LD2 into light of a second color (or a specific color) different from the first color.

When the first sub-pixel SPX1 of the first, second, and third sub-pixels SPX1, SPX2, and SPX3 is a red sub-pixel, the first color conversion layer CCL1 of the first sub-pixel SPX1 may include red quantum dot color-converting particles QD converting the light of the first color emitted from each of the first and second light emitting elements LD1 and LD2 into the light of the second color (e.g., a red light).

When the second sub-pixel SPX2 of the first, second, and third sub-pixels SPX1, SPX2, and SPX3 is a green sub-pixel, the second color conversion layer CCL2 of the second sub-pixel SPX2 may include a green quantum dot color-converting particles QD converting the light of the first color emitted from each of the first and second light emitting elements LD1 and LD2 into the light of the second color (e.g., a green light).

When the third sub-pixel SPX3 of the first, second, and third sub-pixels SPX1, SPX2, and SPX3 is a blue sub-pixel, the third color conversion layer CCL3 of the third sub-pixel SPX3 may include blue quantum dot color-converting particles QD converting the light of the first color emitted from each of the first and second light emitting elements LD1 and LD2 into the light of the second color (e.g., a blue light). In some embodiments, when the third sub-pixel SPX3 is a blue pixel, a light scattering layer including light scattering particles SCT may be provided instead of the third color conversion layer CCL3 including the color-converting particles QD. For example, when the first and second light emitting elements LD1 and LD2 emits blue-based light, the third sub-pixel SPX3 may include a light scattering layer including light scattering particles SCT. In some embodiments, the light scattering layer may be omitted. In some embodiments, when the third sub-pixel SPX3 is a blue pixel, a transparent polymer may be provided instead of the third color conversion layer CCL3.

The first optical layer LCL1, the second optical layer LCL2, and the third optical layer LCL3 may have a substantially similar or identical structure. Detailed description of the first optical layer LCL1 of the first, second, and third optical layers LCL1, LCL2, and LCL3 is provided below.

A capping layer CPL may be disposed on the first color conversion layer CCL1 of the first optical layer LCL1 positioned in the emission area EMA of the first sub-pixel SPX1 and the second bank BNK2 positioned in the non-emission area NEA of the first sub-pixel SPX1.

The capping layer CPL may be provided (e.g., entirely provided) in the display area DA (or the first sub-pixel area SPA1), in which the first sub-pixel SPX1 is positioned, to cover the second bank BNK2 and the first color conversion layer CCL1. The capping layer CPL may be disposed (e.g., directly disposed) on the second bank BNK2 and the first color conversion layer CCL1. The capping layer CPL may be an inorganic insulating layer including an inorganic material. The capping layer CPL may include at least one of a silicon nitride (SiNₓ), a silicon oxide (SiOₓ), a silicon oxynitride (SiOₓN_{y}), and an aluminum oxide (AlOₓ). The capping layer CPL may cover (e.g., completely cover) the second bank BNK2 and the first color conversion layer CCL1 and prevent water or moisture from flowing into the display element layer DPL from the outside.

The capping layer CPL may reduce steps generated by components disposed thereunder and have a flat surface. For example, the capping layer CPL may include an organic insulating layer including an organic material. The capping layer CPL may be a common layer commonly provided to the display area DA, but the disclosure is not limited thereto.

In the embodiment of FIG. 16, a color filter layer CFL may be provided and/or formed on the capping layer CPL. The color filter layer CFL may include color filters CF corresponding to the color of each of the adjacent sub-pixels. For example, the color filter layer CFL may include a first color filter CF1 disposed on the first color conversion layer CCL1 of the first sub-pixel SPX1, a second color filter CF2 disposed on the second color conversion layer CCL2 of the second sub-pixel SPX2, and a third color filter CF3 disposed on the third color conversion layer CCL3 of the third sub-pixel SPX3. The first, second, and third color filters CF1, CF2, and CF3 may overlap each other in the non-emission area NEA in a plan view. Thus, the first, second, and third color filters CF1, CF2, and CF3 may be used as a light blocking member blocking interference of light between the adjacent sub-pixels. Each of the first, second, and third color filters CF1, CF2, and CF3 may include a color filter material that selectively transmits the light of the second color converted in the corresponding color conversion layer. For example, the first color filter CF1 may be a red color filter, the second color filter CF2 may be a green color filter, and third color filter CF3 may be a blue color filter, but the disclosure is not limited thereto. The first color filter CF1 may be disposed on a surface of the capping layer CPL and correspond to the first color conversion layer CCL1 at least in the emission area EMA of the first sub-pixel SPX1. The second color filter CF2 may be disposed on a surface of the capping layer CPL and correspond to the second color conversion layer CCL2 at least in the emission area EMA of the second sub-pixel SPX2. The third color filter CF3 may be disposed on a surface of the capping layer CPL and correspond to the third color conversion layer CCL3 at least in the emission area EMA of the third sub-pixel SPX3.

An encapsulation layer ENC may be provided and/or formed on the color filter layer CFL.

The encapsulation layer ENC may include a fourth insulating layer INS4. The fourth insulating layer INS4 may be an inorganic insulating layer including an inorganic material or an organic insulating layer including an organic material. The fourth insulating layer INS4 may cover (e.g., completely cover) components positioned thereunder and prevent water or moisture from the outside from flowing into the color filter layer CFL and the display element layer DPL.

The first color conversion layer CCL1 and the first optical layer LCL1 including the first color filter CF1 may be disposed on the first and second light emitting elements through continuous processes, and the first sub-pixel SPX1 according to the embodiment described above may emit light having superior color reproducibility through the first color conversion layer CCL1 and the first color filter CF1. Thus, emission efficiency may be improved.

In an embodiment, the fourth insulating layer INS4 may be formed as multiple layers. For example, the fourth insulating layer INS4 may include at least two inorganic insulating layers, and at least one organic insulating layer interposed between the at least two inorganic insulating layers. However, the materials and/or structures of the fourth insulating layer INS4 may be changed in various ways. In some embodiments, at least one of an overcoat layer, a filler layer, and/or an upper substrate may be further disposed on the fourth insulating layer INS4.

In some embodiments, the first color conversion layer CCL1 and the color filter layer CFL may be, as shown in FIG. 17, formed on a surface of a base layer BSL by continuous processes to form a separate substrate (e.g., an upper substrate U_SUB). The upper substrate U_SUB may be combined with the display element layer DPL, which includes the first electrode PE1, the intermediate electrode CTE, and the second electrode PE2, through the intermediate layer CTL.

The intermediate layer CTL may be a transparent adhesion layer (or adhesive layer) that increases an adhesive force between the display element layer DPL and the upper substrate U_SUB. For example, the intermediate layer CTL may be an optically clear adhesive (OCA). However, the disclosure is not limited thereto. In some embodiments, the intermediate layer CTL may convert a reflective index of the light emitting elements LD to travel toward the upper substrate U-SUB, and also be a refractive index conversion layer improving emission luminance of the first sub-pixel SPX1. In some embodiments, the intermediate layer CTL may also include a filler formed of an insulating material having an insulating property and an adhesive property.

The upper substrate U_SUB may form an encapsulation substrate, a window member, and/or an overcoat layer of the display device. The upper substrate U_SUB may include a base layer BSL (or base substrate), a color filter layer CFL, a first capping layer CPL1, a second bank BNK2, a first color conversion layer CCL1, and a second capping layer CPL2.

The base layer BSL may be a rigid substrate or a flexible substrate, and the materials or properties thereof are not limited thereto. The base layer BSL and the substrate SUB may be formed of a same material. For example, the base layer BSL may be formed of a material different from that of the substrate SUB.

The first color filter CF1 of the color filter layer CFL may be formed on a surface of the base layer BSL and correspond to the first color conversion layer CCL1 in the emission area EMA. The first, second, and third color filters CF1, CF2, and CF3 of the color filter layer CFL may overlap each other in the non-emission area NEA in a plan view. Thus, the overlapped first, second, and third color filters CF1, CF2, and CF3 may be used as the light blocking member.

The first capping layer CPL1 may be disposed on the color filter layer CFL. The first capping layer CPL1 may be positioned on the color filter layer CFL and cover the color filter layer CFL. Thus, the first capping layer CPL1 may protect the color filter layer CFL. The first capping layer CPL1 may be an inorganic layer including an inorganic material or an organic layer including an organic material.

The second bank BNK2 and the first color conversion layer CCL1 may be positioned on a surface of the first capping layer CPL1.

The second bank BNK2 may be a dam structure that finally defines the emission area EMA of the first sub-pixel SPX1. The second bank BNK2 may be a dam structure that finally defines the emission area EMA to which the first color conversion layer CCL1 is supplied in the supplying of the first color conversion layer CCL1.

The second capping layer CPL2 may be disposed (e.g., entirely disposed) on the second bank BNK2 and the first color conversion layer CCL1. The second capping layer CPL2 may be disposed between the intermediate layer CTL and the first color conversion layer CCL1 at least in the emission area EMA, and may be disposed between the intermediate layer CTL and the second bank BNK2 at least in the non-emission area NEA. The second capping layer CPL2 may include at least one of a silicon nitride (SiNₓ), a silicon oxide (SiOₓ), a silicon oxynitride (SiOₓN_{y}), and an aluminum oxide (AlOₓ), but the disclosure is not limited thereto.

The upper substrate U_SUB may be combined with display element layer DPL by using the intermediate layer CTL.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the scope of the invention, which is defined by the claims below.

## Claims

1. A pixel (PXL) comprising:
a first sub-pixel (SPA1), a third sub-pixel (SPA2), and a second sub-pixel (SPA3) arranged in a second direction and each including an emission area (EMA) and a non-emission area (NEA), each of the first, second, and third sub-pixels (SPX1, SPX2, SPX3) including:
a pixel circuit layer (PCL) including:
a storage capacitor (Cst);
a first power line (PL1);
a second power line (PL2); and
a passivation layer (PSV) including:
a first via hole (VIH1);
a second via hole (VIH2); and
a third via hole (VIH3);
a first alignment electrode (ALE1) disposed on the passivation layer (PSC) and extending in a first direction (DR1) intersecting the second direction (DR2);
a second alignment electrode (ALE2) extending in the first direction (DR1) and spaced apart from the first alignment electrode (ALE 1) in the second direction (DR2);
a floating pattern (FTP) spaced apart from the first alignment electrode (ALE1); and
a light emitting element (LD) disposed between the first alignment electrode (ALE1) and the second alignment electrode (ALE2), wherein
a first via hole (VIH1) of the first sub-pixel (SPA1), a first via hole (VIH1) of the third sub-pixel (SPA3), and a first via hole (VIH1) of the second sub-pixel (SPA2) are positioned in a same column,
a second via hole (VIH2) of the first sub-pixel (SPA1), a second via hole (VIH2) of the third sub-pixel (SPA3), and a second via hole (VIH2) of the second sub-pixel (SPA2) are positioned in a same column, and
a third via hole (VIH3) of the first sub-pixel (SPA1), a third via hole (VIH3) of the third sub-pixel (SPA3), and a third via hole (VIH3) of the second sub-pixel (SPA2) are positioned in a same column,
wherein
the storage capacitor (Cst) of each of the first, second, and third sub-pixels (SPX1, SPX2, SPX3) includes:
a lower electrode (LE1, LE2, LE3); and
an upper electrode (UE1, UE2, UE3) positioned on the lower electrode (LE1, LE2, LE3),
**characterised in that**
the first via hole (VIH1) exposes a region of the upper electrode (UE1, UE2, UE3),
the second via hole (VIH2) exposes a region of the second power line (PL2), and
the third via hole (VIH3) exposes a region of the floating pattern (FTP),
wherein
the upper electrode (UE) of each of the first, second, and third sub-pixels (SPX1, SPX2, SPX3)is electrically connected to the first alignment electrode (ALE1) through the first via hole (VIH1) of a corresponding one of the first, second, and third sub-pixels (SPX1, SPX2, SPX3),
the second power line (PL2) of each of the first, second, and third sub-pixels (SPX1, SPX2, SPX3) is electrically connected to the second alignment electrode (ALE2) through the second via hole (VIH2) of a corresponding one of the first, second, and third sub-pixels (SPX1, SPX2, SPX3), and
the first power line (PL1) of each of the first, second, and third sub-pixels (SPX1, SPX2, SPX3) is electrically connected to the floating pattern (FTP) through the third via hole (VIH3) of a corresponding one of the first, second, and third sub-pixels (SPX1, SPX2, SPX3).

2. The pixel (PXL) of any preceding claim, wherein the first power line (PL1) is supplied with a first power supply (VDD), the second power line (PL2) is supplied with a second power supply (VSS), the first power supply (VDD) supplies a high potential driving power, and the second power supply (VSS) supplies a low potential driving power.

3. The pixel (PXL) of any preceding claim, wherein in a plan view, the floating pattern (FTP) of the first sub-pixel (SPX1), the floating pattern (FTP) of the third sub-pixel (SPX3), and the floating pattern (FTP) of the second sub-pixel (SPX2) are positioned in a same column.

4. The pixel (PXL) of any preceding claim, wherein
in each of the first, second, and third sub-pixels (SPX1, SPX2, SPX3),
the floating pattern (FTP) is spaced apart from the first alignment electrode (ALE1) in the first direction, and
the floating pattern (FTP) and the first alignment electrode (ALE1) are collinear with each other.

5. The pixel (PXL) of any preceding claim, wherein in a plan view, in each of the first, second, and third sub-pixels (SPX1, SPX2, SPX3), the first via hole (VIH1) and the third via hole (VIH3) are spaced apart from each other in the first direction (DR1) and are positioned in a same row.

6. The pixel (PXL) of any preceding claim, wherein in a plan view, in each of the first, second, and third sub-pixels (SPX1, SPX2, SPX3), the first via hole (VIH1) and the second via hole (VIH2) are positioned in different rows.

7. The pixel (PXL) of any preceding claim, further comprising:
an insulating layer disposed on the first alignment electrode (ALE1) and the second alignment electrode (ALE2); and
a first bank (BNK1) disposed on the insulating layer in the non-emission area (NDA), the first bank (BNK1) including:
a first opening (OP1) corresponding to the emission area (EMA); and
a second opening (OP2) spaced apart from the first opening (OP1),
wherein the first bank (BNK1) completely covers the first to third via holes (VIH3) of each of the first, second, and third sub-pixels (SPX1, SPX2, SPX3).

8. The pixel (PXL) of claim 7, wherein in each of the first, second, and third sub-pixels (SPX1, SPX2, SPX3), the first alignment electrode (ALE1) and the floating pattern (FTP) are spaced apart from each other in the first direction (DR1) within the second opening (OP2) of the first bank (BNK1).

9. The pixel (PXL) of any preceding claim, wherein:
the light emitting element (LD) of each of the first, second, and third sub-pixels (SPX1, SPX2, SPX3) includes:
a first end (EP1); and
a second end (EP2) that is opposite to the first end in the second direction (DR2_,
each of the first, second, and third sub-pixels (SPX1, SPX2, SPX3) further includes:
a first electrode (PE1) overlapping a region of the first alignment electrode (ALE1) in a plan view, electrically connected to the light emitting element (LD), and extending in the first direction (DR1);
a second electrode (PE2) overlapping a region of the second alignment electrode (ALE2) in a plan view, electrically connected to the light emitting element (LD), and extending in the first direction (DR1); and
an intermediate electrode (CTE) spaced apart from the first and second electrodes PE1, PE2) in the second direction between the first electrode (PE1) and the second electrode (PE2),
the second electrode (PE2) is spaced apart from the first electrode (PE1) in the second direction (DR2), and
the intermediate electrode (CTE) overlaps another region of the first alignment electrode (ALE1) and another region of the second alignment electrode (ALE2) in a plan view.

10. The pixel (PXL) of claim 9, wherein the light emitting element (LD) of each of the first, second, and third sub-pixels (SPX1, SPX2, SPX3) includes:
a first light emitting element (LD1) positioned between the region of the first alignment electrode (ALE1) and the another region of the second alignment electrode (ALE2), the first light emitting element (LD1) including:
a first end (EP1) electrically connected to the first electrode (PE1); and
a second end (EP2) electrically connected to the intermediate electrode (CTE); and
a second light emitting element (LD2) positioned between the another region of the first alignment electrode (ALE1) and the region of the second alignment electrode (ALE2), the second light emitting element (LD2) including:
a first end (EP1) electrically connected to the intermediate electrode (CTE); and
a second end (EP2)electrically connected to the second electrode (PE2).

11. The pixel (PXL) of any preceding claim, wherein
the pixel circuit layer (PCL) includes:
a first connecting line (CNL1) extending in the second direction (DR2); and
a second connecting line (CNL2) extending in the second direction (DR2),
the third via hole (VIH3) of the first sub-pixel (SPX1), the third via hole (VIH3) of the second sub-pixel (SPX2), and the third via hole (VIH3) of the third sub-pixel (SPX3)overlap the second connecting line (CNL2) in a plan view,
the second via hole (VIH2) of the first sub-pixel (SPX1), the second via hole (VIH2) of the second sub-pixel (SPX2), and the third via hole (VIH3) of the third sub-pixel (SPX3) overlap the first connecting line (CNL1) in a plan view,
the first connecting line (CNL1) and the first power line (PL1) are integral with each other, and
the second connecting line (CNL2) and the second power line (PL2) are integral with each other.

12. The pixel (PXL) of claim 11, wherein
the second connecting line (CNL2) is electrically connected to the floating pattern (FTP) of a corresponding one of the first, second, and third sub-pixels (SPX1, SPX2, SPX3) through the third via hole (VIH3) of each of the first, second, and third sub-pixels (SPX1, SPX2, SPX3), and
the first connecting line (CNL1) is electrically connected to the second alignment electrode (ALE2) of a corresponding one of the first, second, and third sub-pixels (SPX1, SPX2, SPX3) through the second via hole (VIH2) of each of the first, second, and third sub-pixels (SPX1, SPX2, SPX3).

13. A display device comprising:
a display area (DA) and a non-display area (NDA); and
at least one pixel (PXL) according to any preceding claim, provided in the display area (DA).

## Patentansprüche

1. Pixel (PXL), umfassend:
ein erstes Subpixel (SPA1), ein drittes Subpixel (SPA2) und ein zweites Subpixel (SPA3), die in einer zweiten Richtung angeordnet sind und jeweils einen Emissionsbereich (EMA) und einen Nicht-Emissionsbereich (NEA) beinhalten, wobei jedes des ersten, des zweiten und des dritten Subpixels (SPX1, SPX2, SPX3) Folgendes beinhaltet:
eine Pixelschaltungsschicht (PCL), die Folgendes beinhaltet:
ein Speicherkondensator (Cst);
eine erste Stromleitung (PL1);
eine zweite Stromleitung (PL2); und
eine Passivierungsschicht (PSV), die Folgendes beinhaltet:
eine erste Durchkontaktierung (VIH1);
eine zweite Durchkontaktierung (VIH2); und
eine dritte Durchkontaktierung (VIH3);
eine erste Ausrichtungselektrode (ALE1), die auf der Passivierungsschicht (PSC) angeordnet ist und sich in einer ersten Richtung (DR1) erstreckt, die die zweite Richtung (DR2) schneidet;
eine zweite Ausrichtungselektrode (ALE2), die sich in der ersten Richtung (DR1) erstreckt und von der ersten Ausrichtungselektrode (ALE1) in der zweiten Richtung (DR2) beabstandet ist;
eine potentialfreie Struktur (FTP), die von der ersten Ausrichtungselektrode (ALE1) beabstandet ist; und
ein lichtemittierendes Element (LD), das zwischen der ersten Ausrichtungselektrode (ALE1) und der zweiten Ausrichtungselektrode (ALE2) angeordnet ist, wobei
eine erste Durchkontaktierung (VIH1) des ersten Subpixels (SPA1), eine erste Durchkontaktierung (VIH1) des dritten Subpixels (SPA3) und eine erste Durchkontaktierung (VIH1) des zweiten Subpixels (SPA2) in einer selben Spalte positioniert sind,
eine zweite Durchkontaktierung (VIH2) des ersten Subpixels (SPA1), eine zweite Durchkontaktierung (VIH2) des dritten Subpixels (SPA3) und eine zweite Durchkontaktierung (VIH2) des zweiten Subpixels (SPA2) in einer selben Spalte positioniert sind, und
eine dritte Durchkontaktierung (VIH3) des ersten Subpixels (SPA1), eine dritte Durchkontaktierung (VIH3) des dritten Subpixels (SPA3) und eine dritte Durchkontaktierung (VIH3) des zweiten Subpixels (SPA2) in einer selben Spalte positioniert sind,
wobei
der Speicherkondensator (Cst) jedes des ersten, des zweiten und des dritten Subpixels (SPX1, SPX2, SPX3) Folgendes beinhaltet:
eine untere Elektrode (LE1, LE2, LE3); und
eine obere Elektrode (UE1, UE2, UE3), die auf der unteren Elektrode (LE1, LE2, LE3) positioniert ist,
**dadurch gekennzeichnet, dass**
die erste Durchkontaktierung (VIH1) einen Bereich der oberen Elektrode (UE1, UE2, UE3) freilegt,
die zweite Durchkontaktierung (VIH2) einen Bereich der zweiten Stromleitung (PL2) freilegt, und
die dritte Durchkontaktierung (VIH3) einen Bereich der potentialfreien Struktur (FTP) freilegt,
wobei
die obere Elektrode (UE) jedes des ersten, des zweiten und des dritten Subpixels (SPX1, SPX2, SPX3) durch die erste Durchkontaktierung (VIH1) eines entsprechenden des ersten, des zweiten und des dritten Subpixels (SPX1, SPX2, SPX3) elektrisch mit der ersten Ausrichtungselektrode (ALE1) verbunden ist,
die zweite Stromleitung (PL2) jedes des ersten, des zweiten und des dritten Subpixels (SPX1, SPX2, SPX3) durch die zweite Durchkontaktierung (VIH2) eines entsprechenden des ersten, des zweiten und des dritten Subpixels (SPX1, SPX2, SPX3) elektrisch mit der zweiten Ausrichtungselektrode (ALE2) verbunden ist, und
die erste Stromleitung (PL1) jedes des ersten, des zweiten und des dritten Subpixels (SPX1, SPX2, SPX3) durch die dritte Durchkontaktierung (VIH3) eines entsprechenden des ersten, des zweiten und des dritten Subpixels (SPX1, SPX2, SPX3) elektrisch mit der potentialfreien Struktur (FTP) verbunden ist.

2. Pixel (PXL) nach einem vorstehenden Anspruch, wobei
die erste Stromleitung (PL1) mit einer ersten Stromzufuhr (VDD) versorgt wird, die zweite Stromleitung (PL2) mit einer zweiten Stromzufuhr (VSS) versorgt wird, die erste Stromzufuhr (VDD) eine Antriebsenergie mit hohem Potential zuführt, und die zweite Stromzufuhr (VSS) eine Antriebsenergie mit niedrigem Potential zuführt.

3. Pixel (PXL) nach einem vorstehenden Anspruch, wobei in einer Draufsicht die potentialfreie Struktur (FTP) des ersten Subpixels (SPX1), die potentialfreie Struktur (FTP) des dritten Subpixels (SPX3) und die potentialfreie Struktur (FTP) des zweiten Subpixels (SPX2) in einer selben Spalte positioniert sind.

4. Pixel (PXL) nach einem vorstehenden Anspruch, wobei
in jedem des ersten, des zweiten und des dritten Subpixels (SPX1, SPX2, SPX3)
die potentialfreie Struktur (FTP) von der ersten Ausrichtungselektrode (ALE1) in der ersten Richtung beabstandet ist, und
die potentialfreie Struktur (FTP) und die erste Ausrichtungselektrode (ALE1) kollinear zueinander sind.

5. Pixel (PXL) nach einem vorstehenden Anspruch, wobei in einer Draufsicht in jedem des ersten, des zweiten und des dritten Subpixels (SPX1, SPX2, SPX3) die erste Durchkontaktierung (VIH1) und die dritte Durchkontaktierung (VIH3) in der ersten Richtung (DR1) voneinander beabstandet und in einer selben Reihe positioniert sind.

6. Pixel (PXL) nach einem vorstehenden Anspruch, wobei in einer Draufsicht in jedem des ersten, des zweiten und des dritten Subpixels (SPX1, SPX2, SPX3) die erste Durchkontaktierung (VIH1) und die zweite Durchkontaktierung (VIH2) in unterschiedlichen Reihen positioniert sind.

7. Pixel (PXL) nach einem vorstehenden Anspruch, weiter umfassend:
eine Isolierschicht, die auf der ersten Ausrichtungselektrode (ALE1) und der zweiten Ausrichtungselektrode (ALE2) angeordnet ist; und
eine erste Bank (BNK1), die auf der Isolierschicht im Nicht-Emissionsbereich (NDA) angeordnet ist, wobei die erste Bank (BNK1) Folgendes beinhaltet:
eine erste Öffnung (OP1), die dem Emissionsbereich (EMA) entspricht; und
eine zweite Öffnung (OP2), die von der ersten Öffnung (OP1) beabstandet ist,
wobei die erste Bank (BNK1) die ersten bis dritten Durchkontaktierungen (VIH3) jedes des ersten, des zweiten und des dritten Subpixels (SPX1, SPX2, SPX3) vollständig abdeckt.

8. Pixel (PXL) nach Anspruch 7, wobei in jedem des ersten, des zweiten und des dritten Subpixels (SPX1, SPX2, SPX3) die erste Ausrichtungselektrode (ALE1) und die potentialfreie struktur (FTP) in der ersten Richtung (DR1) innerhalb der zweiten Öffnung (OP2) der ersten Bank (BNK1) voneinander beabstandet sind.

9. Pixel (PXL) nach einem vorstehenden Anspruch, wobei:
das lichtemittierende Element (LD) jedes des ersten, des zweiten und des dritten Subpixels (SPX1, SPX2, SPX3) Folgendes beinhaltet:
ein erstes Ende (EP1); und
ein zweites Ende (EP2), das dem ersten Ende in der zweiten Richtung (DR2) gegenüberliegt, wobei jedes des ersten, des zweiten und des dritten Subpixels (SPX1, SPX2, SPX3) weiter Folgendes beinhaltet:
eine erste Elektrode (PE1), die in einer Draufsicht einen Bereich der ersten Ausrichtungselektrode (ALE1) überlappt, elektrisch mit dem lichtemittierenden Element (LD) verbunden ist und sich in der ersten Richtung (DR1) erstreckt;
eine zweite Elektrode (PE2), die in einer Draufsicht einen Bereich der zweiten Ausrichtungselektrode (ALE2) überlappt, elektrisch mit dem lichtemittierenden Element (LD) verbunden ist und sich in die erste Richtung (DR1) erstreckt; und
eine Zwischenelektrode (CTE), die von der ersten und zweiten Elektrode (PE1, PE2) in der zweiten Richtung zwischen der ersten Elektrode (PE1) und der zweiten Elektrode (PE2) beabstandet ist,
die zweite Elektrode (PE2) von der ersten Elektrode (PE1) in der zweiten Richtung (DR2) beabstandet ist, und
die Zwischenelektrode (CTE) in einer Draufsicht einen weiteren Bereich der ersten Ausrichtungselektrode (ALE1) und einen weiteren Bereich der zweiten Ausrichtungselektrode (ALE2) überlappt.

10. Pixel (PXL) nach Anspruch 9, wobei das lichtemittierende Element (LD) jedes des ersten, des zweiten und des dritten Subpixels (SPX1, SPX2, SPX3) Folgendes beinhaltet:
ein erstes lichtemittierendes Element (LD1), das zwischen dem Bereich der ersten Ausrichtungselektrode (ALE1) und dem weiteren Bereich der zweiten Ausrichtungselektrode (ALE2) positioniert ist, wobei das erste lichtemittierende Element (LD1) Folgendes beinhaltet:
ein erstes Ende (EP1), das elektrisch mit der ersten Elektrode (PE1) verbunden ist; und
ein zweites Ende (EP2), das elektrisch mit der Zwischenelektrode (CTE) verbunden ist; und
ein zweites lichtemittierendes Element (LD2), das zwischen dem weiteren Bereich der ersten Ausrichtungselektrode (ALE1) und dem Bereich der zweiten Ausrichtungselektrode (ALE2) positioniert ist, wobei das zweite lichtemittierende Element (LD2) Folgendes beinhaltet:
ein erstes Ende (EP1), das elektrisch mit der Zwischenelektrode (CTE) verbunden ist; und
ein zweites Ende (EP2), das elektrisch mit der zweiten Elektrode (PE2) verbunden ist.

11. Pixel (PXL) nach einem vorstehenden Anspruch, wobei die Pixelschaltungsschicht (PCL) Folgendes beinhaltet:
eine erste Verbindungsleitung (CNL1), die sich in der zweiten Richtung (DR2) erstreckt; und
eine zweite Verbindungsleitung (CNL2), die sich in der zweiten Richtung (DR2) erstreckt,
die dritte Durchkontaktierung (VIH3) des ersten Subpixels (SPX1), die dritte Durchkontaktierung (VIH3) des zweiten Subpixels (SPX2) und die dritte Durchkontaktierung (VIH3) des dritten Subpixels (SPX3) die zweite Verbindungslinie (CNL2) in einer Draufsicht überlappen,
die zweite Durchkontaktierung (VIH2) des ersten Subpixels (SPX1), die zweite Durchkontaktierung (VIH2) des zweiten Subpixels (SPX2) und die dritte Durchkontaktierung (VIH3) des dritten Subpixels (SPX3) die erste Verbindungslinie (CNL1) in einer Draufsicht überlappen,
die erste Verbindungsleitung (CNL1) und die erste Stromleitung (PL1) integral miteinander sind, und
die zweite Verbindungsleitung (CNL2) und die zweite Stromleitung (PL2) integral miteinander sind.

12. Pixel (PXL) nach Anspruch 11, wobei die zweite Verbindungsleitung (CNL2) elektrisch mit der potentialfreien Struktur (FTP) eines entsprechenden des ersten, des zweiten und des dritten Subpixels (SPX1, SPX2, SPX3) durch die dritte Durchkontaktierung (VIH3) jedes des ersten, des zweiten und des dritten Subpixels (SPX1, SPX2, SPX3) verbunden ist, und
die erste Verbindungsleitung (CNL1) durch die zweite Durchkontaktierung (VIH2) jedes des ersten, des zweiten und des dritten Subpixels (SPX1, SPX2, SPX3) elektrisch mit der zweiten Ausrichtungselektrode (ALE2) eines entsprechenden des ersten, des zweiten und des dritten Subpixels (SPX1, SPX2, SPX3) verbunden ist.

13. Anzeigevorrichtung, umfassend:
einen Anzeigebereich (DA) und einen Nicht-Anzeigebereich (NDA); und
mindestens ein Pixel (PXL) nach einem vorstehenden Anspruch, das im Anzeigebereich (DA) bereitgestellt ist.

## Revendications

1. Pixel (PXL) comprenant :
un premier sous-pixel (SPA1), un troisième sous-pixel (SPA2) et un deuxième sous-pixel (SPA3) agencés dans une seconde direction et incluant chacun une zone d'émission (EMA) et une zone de non-émission (NEA), chacun des premier, deuxième et troisième sous-pixels (SPX1, SPX2, SPX3) incluant :
une couche de circuit de pixels (PCL) incluant :
un condensateur de stockage (Cst) ;
une première ligne électrique (PL1) ;
une seconde ligne électrique (PL2) ; et
une couche de passivation (PSV) incluant :
un premier trou d'interconnexion (VIH1) ;
un deuxième trou d'interconnexion (VIH2) ; et
un troisième trou d'interconnexion (VIH3) ;
une première électrode d'alignement (ALE1) disposée sur la couche de passivation (PSC) et s'étendant dans une première direction (DR1) coupant la seconde direction (DR2) ;
une seconde électrode d'alignement (ALE2) s'étendant dans la première direction (DR1) et espacée de la première électrode d'alignement (ALE1) dans la seconde direction (DR2) ;
un motif flottant (FTP) espacé de la première électrode d'alignement (ALE1) ; et
un élément électroluminescent (LD) disposé entre la première électrode d'alignement (ALE1) et la seconde électrode d'alignement (ALE2), dans lequel
un premier trou d'interconnexion (VIH1) du premier sous-pixel (SPA1), un premier trou d'interconnexion (VIH1) du troisième sous-pixel (SPA3) et un premier trou d'interconnexion (VIH1) du deuxième sous-pixel (SPA2) sont positionnés dans une même colonne,
un deuxième trou d'interconnexion (VIH2) du premier sous-pixel (SPA1), un deuxième trou d'interconnexion (VIH2) du troisième sous-pixel (SPA3) et un deuxième trou d'interconnexion (VIH2) du deuxième sous-pixel (SPA2) sont positionnés dans une même colonne, et
un troisième trou d'interconnexion (VIH3) du premier sous-pixel (SPA1), un troisième trou d'interconnexion (VIH3) du troisième sous-pixel (SPA3) et un troisième trou d'interconnexion (VIH3) du deuxième sous-pixel (SPA2) sont positionnés dans une même colonne,
dans lequel
le condensateur de stockage (Cst) de chacun des premier, deuxième et troisième sous-pixels (SPX1, SPX2, SPX3) inclut :
une électrode inférieure (LE1, LE2, LE3) ; et
une électrode supérieure (UE1, UE2, UE3) positionnée sur l'électrode inférieure (LE1, LE2, LE3),
**caractérisé en ce que**
le premier trou d'interconnexion (VIH1) expose une région de l'électrode supérieure (UE1, UE2, UE3),
le deuxième trou d'interconnexion (VIH2) expose une région de la seconde ligne électrique (PL2), et
le troisième trou d'interconnexion (VIH3) expose une région du motif flottant (FTP),
dans lequel
l'électrode supérieure (UE) de chacun des premier, deuxième et troisième sous-pixels (SPX1, SPX2, SPX3) est raccordée électriquement à la première électrode d'alignement (ALE1) via le premier trou d'interconnexion (VIH1) d'un sous-pixel correspondant parmi les premier, deuxième et troisième sous-pixels (SPX1, SPX2, SPX3),
la seconde ligne électrique (PL2) de chacun des premier, deuxième et troisième sous-pixels (SPX1, SPX2, SPX3) est raccordée électriquement à la seconde électrode d'alignement (ALE2) via le deuxième trou d'interconnexion (VIH2) d'un sous-pixel correspondant parmi les premier, deuxième et troisième sous-pixels (SPX1, SPX2, SPX3), et
la première ligne électrique (PL1) de chacun des premier, deuxième et troisième sous-pixels (SPX1, SPX2, SPX3) est raccordée électriquement au motif flottant (FTP) via le troisième trou d'interconnexion (VIH3) d'un sous-pixel correspondant parmi les premier, deuxième et troisième sous-pixels (SPX1, SPX2, SPX3).

2. Pixel (PXL) selon une quelconque revendication précédente, dans lequel
la première ligne électrique (PL1) est alimentée par une première alimentation électrique (VDD),
la seconde ligne électrique (PL2) est alimentée par une seconde alimentation électrique (VSS),
la première alimentation électrique (VDD) fournit une puissance d'entraînement à potentiel élevé, et
la seconde alimentation électrique (VSS) fournit une puissance d'entraînement à faible potentiel.

3. Pixel (PXL) selon une quelconque revendication précédente, dans lequel, dans une vue en plan, le motif flottant (FTP) du premier sous-pixel (SPX1), le motif flottant (FTP) du troisième sous-pixel (SPX3) et le motif flottant (FTP) du deuxième sous-pixel (SPX2) sont positionnés dans une même colonne.

4. Pixel (PXL) selon une quelconque revendication précédente, dans lequel
dans chacun des premier, deuxième et troisième sous-pixels (SPX1, SPX2, SPX3),
le motif flottant (FTP) est espacé de la première électrode d'alignement (ALE1) dans la première direction, et
le motif flottant (FTP) et la première électrode d'alignement (ALE1) sont colinéaires l'un avec l'autre.

5. Pixel (PXL) selon une quelconque revendication précédente, dans lequel, dans une vue en plan, dans chacun des premier, deuxième et troisième sous-pixels (SPX1, SPX2, SPX3), le premier trou d'interconnexion (VIH1) et le troisième trou d'interconnexion (VIH3) sont espacés l'un de l'autre dans la première direction (DR1) et sont positionnés dans une même rangée.

6. Pixel (PXL) selon une quelconque revendication précédente, dans lequel, dans une vue en plan, dans chacun des premier, deuxième et troisième sous-pixels (SPX1, SPX2, SPX3), le premier trou d'interconnexion (VIH1) et le deuxième trou d'interconnexion (VIH2) sont positionnés dans des rangées différentes.

7. Pixel (PXL) selon une quelconque revendication précédente, comprenant en outre :
une couche isolante disposée sur la première électrode d'alignement (ALE1) et la seconde électrode d'alignement (ALE2) ; et
une première banque (BNK1) disposée sur la couche isolante dans la zone de non-émission (NDA), la première banque (BNK1) incluant :
une première ouverture (OP1) correspondant à la zone d'émission (EMA) ; et
une seconde ouverture (OP2) espacée de la première ouverture (OP1),
dans lequel la première banque (BNK1) recouvre entièrement les premier à troisième trous d'interconnexion (VIH3) de chacun des premier, deuxième et troisième sous-pixels (SPX1, SPX2, SPX3).

8. Pixel (PXL) selon la revendication 7, dans lequel dans chacun des premier, deuxième et troisième sous-pixels (SPX1, SPX2, SPX3), la première électrode d'alignement (ALE1) et le motif flottant (FTP) sont espacés l'un de l'autre dans la première direction (DR1) à l'intérieur de la seconde ouverture (OP2) de la première banque (BNK1).

9. Pixel (PXL) selon une quelconque revendication précédente, dans lequel :
l'élément électroluminescent (LD) de chacun des premier, deuxième et troisième sous-pixels (SPX1, SPX2, SPX3) inclut :
une première extrémité (EP1) ; et
une seconde extrémité (EP2) qui est opposée à la première extrémité dans la seconde direction (DR2), chacun des premier, deuxième et troisième sous-pixels (SPX1, SPX2, SPX3) inclut en outre :
une première électrode (PE1) chevauchant une région de la première électrode d'alignement (ALE1) dans une vue en plan, raccordée électriquement à l'élément électroluminescent (LD) et s'étendant dans la première direction (DR1) ;
une seconde électrode (PE2) chevauchant une région de la seconde électrode d'alignement (ALE2) dans une vue en plan, raccordée électriquement à l'élément électroluminescent (LD) et s'étendant dans la première direction (DR1) ; et
une électrode intermédiaire (CTE) espacée des première et seconde électrodes (PE1, PE2) dans la seconde direction entre la première électrode (PE1) et la seconde électrode (PE2),
la seconde électrode (PE2) est espacée de la première électrode (PE1) dans la seconde direction (DR2), et
l'électrode intermédiaire (CTE) chevauche une autre région de la première électrode d'alignement (ALE1) et une autre région de la seconde électrode d'alignement (ALE2) dans une vue en plan.

10. Pixel (PXL) selon la revendication 9, dans lequel l'élément électroluminescent (LD) de chacun des premier, deuxième et troisième sous-pixels (SPX1, SPX2, SPX3) inclut :
un premier élément électroluminescent (LD1) positionné entre la région de la première électrode d'alignement (ALE1) et l'autre région de la seconde électrode d'alignement (ALE2), le premier élément électroluminescent (LD1) incluant :
une première extrémité (EP1) raccordée électriquement à la première électrode (PE1) ; et
une seconde extrémité (EP2) raccordée électriquement à l'électrode intermédiaire (CTE) ; et
un second élément électroluminescent (LD2) positionné entre l'autre région de la première électrode d'alignement (ALE1) et la région de la seconde électrode d'alignement (ALE2), le second élément électroluminescent (LD2) incluant :
une première extrémité (EP1) raccordée électriquement à l'électrode intermédiaire (CTE) ; et
une seconde extrémité (EP2) raccordée électriquement à la seconde électrode (PE2).

11. Pixel (PXL) selon une quelconque revendication précédente, dans lequel la couche de circuit de pixels (PCL) inclut :
une première ligne de raccordement (CNL1) s'étendant dans la seconde direction (DR2) ; et
une seconde ligne de raccordement (CNL2) s'étendant dans la seconde direction (DR2),
le troisième trou d'interconnexion (VIH3) du premier sous-pixel (SPX1), le troisième trou d'interconnexion (VIH3) du deuxième sous-pixel (SPX2) et le troisième trou d'interconnexion (VIH3) du troisième sous-pixel (SPX3) chevauchent la seconde ligne de raccordement (CNL2) dans une vue en plan,
le deuxième trou d'interconnexion (VIH2) du premier sous-pixel (SPX1), le deuxième trou d'interconnexion (VIH2) du deuxième sous-pixel (SPX2) et le troisième trou d'interconnexion (VIH3) du troisième sous-pixel (SPX3) chevauchent la première ligne de raccordement (CNL1) dans une vue en plan,
la première ligne de raccordement (CNL1) et la première ligne électrique (PL1) sont solidaires l'une de l'autre, et
la seconde ligne de raccordement (CNL2) et la seconde ligne électrique (PL2) sont solidaires l'une de l'autre.

12. Pixel (PXL) selon la revendication 11, dans lequel
la seconde ligne de raccordement (CNL2) est raccordée électriquement au motif flottant (FTP) d'un sous-pixel correspondant parmi les premier, deuxième et troisième sous-pixels (SPX1, SPX2, SPX3) via le troisième trou d'interconnexion (VIH3) de chacun des premier, deuxième et troisième sous-pixels (SPX1, SPX2, SPX3), et
la première ligne de raccordement (CNL1) est raccordée électriquement à la seconde électrode d'alignement (ALE2) d'un sous-pixel correspondant parmi les premier, deuxième et troisième sous-pixels (SPX1, SPX2, SPX3) via le deuxième trou d'interconnexion (VIH2) de chacun des premier, deuxième et troisième sous-pixels (SPX1, SPX2, SPX3).

13. Dispositif d'affichage comprenant :
une zone d'affichage (DA) et une zone de non-affichage (NDA) ; et
au moins un pixel (PXL) selon une quelconque revendication précédente, prévu dans la zone d'affichage (DA).
